(19) Europäisches Patentamt
European Patent Office
Office européen des brevets

(11) EP 0 798 908 B1

(12) EUROPEAN PATENT SPECIFICATION

(45) Date of publication and mention of the grant of the patent:
**16.06.1999 Bulletin 1999/24**

(51) Int Cl.[6]: **H04M 1/65**

(21) Application number: **97100335.5**

(22) Date of filing: **10.01.1997**

# (54) Speech encoder/decoder with speech recording and reproduction functions

Sprachkodierer/-dekodierer mit Funktionen zur Aufzeichnung und Wiedergabe von Sprache

Codeur et décodeur de la parole ayant des fonctions, d'enregistrement et reproduction de parole

(84) Designated Contracting States:
**DE FR GB**

(30) Priority: **29.03.1996 JP 7607296**

(43) Date of publication of application:
**01.10.1997 Bulletin 1997/40**

(73) Proprietor: **MITSUBISHI DENKI KABUSHIKI KAISHA**
**Tokyo 100 (JP)**

(72) Inventors:
- **Murata, Kenji**
  **Chiyoda-ku, Tokyo 100 (JP)**
- **Yasui, Ikuo**
  **Chiyoda-ku, Tokyo 100 (JP)**
- **Matsuishi, Tsugumi**
  **Chiyoda-ku, Tokyo 100 (JP)**
- **Goto, Koji**
  **Chiyoda-ku, Tokyo 100 (JP)**

(74) Representative: **Prüfer, Lutz H., Dipl.-Phys. et al**
**PRÜFER & PARTNER,**
**Patentanwälte,**
**Harthauser Strasse 25d**
**81545 München (DE)**

(56) References cited:
**EP-A- 0 552 005** **EP-A- 0 634 845**
**US-A- 5 195 128** **US-A- 5 384 828**

- **IBM TECHNICAL DISCLOSURE BULLETIN, vol. 38, no. 10, October 1995, NEW YORK, US, pages 469-472, XP000540562 ANONYMOUS: "Coordinated Compressed Connection"**
- **PATENT ABSTRACTS OF JAPAN vol. 018, no. 329 (E-1566), 22 June 1994 & JP 06 078049 A (SONY), 18 March 1994,**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 798 908 B1

## Description

BACKGROUND OF THE INVENTION

Field of the Invention

The present invention relates to a speech encoder/decoder with speech recording and reproduction functions for use in communication terminals or the like. It particularly relates to a speech encoder/decoder with speech recording and reproduction functions using ADPCM (Adaptive Differential Pulse Code Modulation) speech coding system.

Description of the Background Art

With communication terminals used in personal handy phone system (PHS) or digital European cordless telephone (DECT), speech signals are efficiently compression-coded for transmission in order to reduce the amount of data to be transmitted and the coded speech data is decoded at the receiving side.

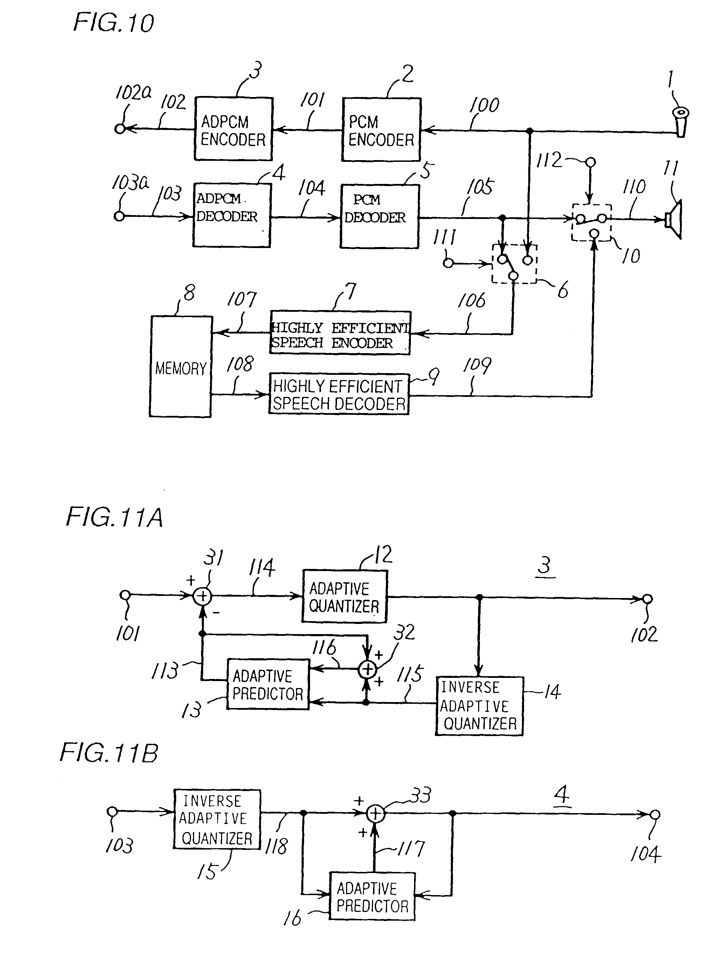

Fig. 10 shows the configuration of a speech encoder/decoder portion with recording and reproduction functions in a conventional communication terminal. In Fig. 10, the conventional speech encoder/decoder includes a PCM encoder 2 for receiving an analog speech signal 100 input from a microphone 1 for conversion into a PCM (Pulse Code Modulation) code 101, an ADPCM encoder 3 for compressing the PCM code 101 into an ADPCM (Adaptive Differential Pulse Code Modulation) code 102 for transmission on a transmission line 102a, an ADPCM decoder 4 for receiving an ADPCM code 103 on a receiving line 103a for decompression into a PCM code 104, and a PCM decoder 5 for transforming the PCM code 104 into an analog speech signal 105. Transmission line 102a and receiving line 103a may be connected to a time-division multiplex circuit and then coupled to an antenna via a transmitting and receiving processing circuit. Furthermore, transmission line 102a and receiving line 103a may be connected to a transmission line for wire communication, not for wireless communication.

The speech encoder/decoder with recording and reproduction functions further includes a recording input change-over switch 6 for selecting one of analog speech signal 100 from microphone 1 and analog speech signal 105 from PCM decoder 5 according to a recording input switching signal 111, a highly efficient speech encoder 7 for applying a predetermined, highly efficiency coding processing to an analog speech signal 106 from recording input change-over switch 6 for compression into a highly efficient speech code 107, a memory 8 for storing therein highly efficient speech code 107, a highly efficient speech decoder 9 for converting a highly efficient speech code 108 read from memory 8 into an analog speech signal 109, a reproduction output change-over switch 10 for selecting one of analog speech signal 105 from PCM decoder 5 and analog speech signal 109 from highly efficient speech decoder 9 according to a reproduction output switching signal 112, and a speaker 11 for outputting an analog speech signal 110 from reproduction output change-over switch 10. Highly efficient coding processing may be any processing capable of highly efficiently coding analog speech signals.

The speech encoder/decoder has three modes of operation. A first mode is the normal communication mode for communicating with the counterpart, a second mode is the recording mode for storing speech information in memory 8, and a third mode is the reproduction mode for reproducing speech information stored in memory 8.

In the normal communication mode, reproduction output switching signal 112 is set to select reproduction output in the normal communication mode, and a reproduction output change-over switch 10 is set to select analog speech signal 105 output from PCM decoder 5 and transfer it to speaker 11. Highly efficient speech encoder 7 and highly efficient speech decoder 9 are set to non-operating state, and writing and reading of speech information into and from memory 8 are stopped. Analog speech signal 100 input from microphone 1 is converted into ADPCM code 102 via PCM encoder 2 and ADPCM encoder 3 and transferred on transmission line 102a. ADPCM code 103 from receiving line 103a is converted into analog speech signal 105 by ADPCM decoder 4 and PCM decoder 5 and supplied to speaker 11. That is, in the normal communication mode, speech encoding processing is applied to analog speech signal 100 supplied from microphone 1, and speech decoding processing is applied to ADPCM code 103 received on receiving line 103a.

In the recording mode, recording input change-over switch 6 selects one of analog speech signal 100 supplied from microphone 1 and analog speech signal 105 supplied from PCM decoder 5 and supplies a selected analog speed signal 106 to highly efficient speech encoder 7. The recording operation may be done in parallel with the normal communication mode. Highly efficient speech encoder 7 applies a predetermined highly efficient encoding to analog speech signal 106 to generate and store highly efficient speech code 107 in memory 8.

In the reproduction mode, reproduction output change-over switch 10 is set to select analog speech signal 109 from highly efficient speech decoder 9 according to reproduction output switching signal 112. Highly efficient speech decoder 9 highly efficiently decodes highly efficient speech code 108 read from memory 8 to reproduce and supply analog speech signal 109 to speaker 11 via reproduction output change-over switch 10.

The reproduction mode of operation may be done in parallel with the normal communication mode. When the normal communication mode of operation is done in parallel with the reproduction mode of operation, ADPCM decoder 4 continues to decode ADPCM code 103 received via receiving line 103a, since coincidence in internal state between ADPCM decoder 4 and the ADPCM encoder of its counterpart need be maintained. If the internal states do not coincide with each other, a received ADPCM code cannot be precisely decoded, since a differential prediction value is used in ADPCM encoding/decoding processing, as described in detail later.

As described above, a conventional speech encoder/decoder with speech recording and reproduction functions has PCM encoder 2 and ADPCM encoder 3 for encoding processing for communication, it has ADPCM decoder 4 and PCM decoder 5 for decoding processing for communication, it further has highly efficient speech encoder 7 for encoding processing for recording, and it further has highly efficient speech decoder 9 for decoding processing for reproduction. Thus, a speech encoder and a speech decoder are required exclusively for recording and reproduction so that the number of device components and the scale of circuit and power consumption increase, leading to a serious obstacle against use in mobile communication terminals which are particularly required to be miniaturized in size and to consume less electric power.

These problems will be solved by the configuration in which PCM encoder 2, ADPCM encoder 3, ADPCM decoder 4 and PCM decoder 5 used for communication can be also used for recording and reproduction. However, this causes the problem described below.

Fig. 11A, which is based on ITU-T Recommendation G. 726 (Geneva, 1990), schematically shows the internal configuration of ADPCM encoder 3 shown in Fig. 10. In Fig. 11A, ADPCM encoder 3 includes a subtractor 31 for taking the difference between PCM code 101 and a prediction signal 113 to generate a differential signal 114, an adaptive quantizer 12 for adaptively quantizing the differential signal 114 for outputting as a ADPCM code 102, an inverse adaptive quantizer 14 for inversely quantizing ADPCM code 102 adaptively, to generate a quantized differential signal 115, an adder 32 for adding prediction signal 113 and quantized differential signal 115 to generate a reproduction signal 116, and an adaptive predictor 13 receiving quantized differential signal 115 and reproduction signal 116 for performing adaptive prediction to generate prediction signal 113.

Fig. 11B, which is also based on the above recommendation, schematically shows the configuration of ADPCM decoder 4 shown in Fig. 10. In Fig. 11B, ADPCM decoder 4 includes an inverse adaptive quantizer 15 for inversely quantizing ADPCM code 103 adaptively, to generate a quantized differential signal 118, an adder 33 for adding quantized differential signal 118 and a prediction signal 117 together to reproduce PCM code 104, and an adaptive predictor 16 for performing adaptive prediction according to PCM code 104 from adder 33 and quantized differential signal 118 from inverse adaptive quantizer 15 to generate and supply prediction signal 117 to adder 33.

The configuration of internal feedback loop of ADPCM encoder 3, i.e., of the feedback loop configured by inverse adaptive quantizer 14, adder 32 and adaptive predictor 13 is the same as the internal configuration of ADPCM decoder 4. At transmitting and receiving sides, the ADPCM encoder on one side and the ADPCM decoder on the other side have their respective inverse adaptive quantizers and adaptive predictors operate such that their internal states completely coincide. That is, internal states of inverse adaptive quantizer 14 and adaptive predictor 13 in ADPCM encoder 3 of the transmitting side is rendered the same as those of inverse adaptive quantizer 15 and adaptive predictor 16 included in ADPCM decoder 4 of the receiving side. Thus, precise reproduction of speech signals can be achieved.

Thus, when a PCM encoder/decoder being used for communication is used for recording and reproduction, the following problem will be caused. That is, when an ADPCM code recorded in memory 8 is reproduced and heard, the ADPCM code read from memory 8 is supplied to ADPCM decoder 4. In doing so, there is no continuity between an ADPCM code supplied from ADPCM encoder 3 of the counterpart and the ADPCM code read from memory 8. Thus, when reproduction is done in parallel with the normal communication mode, the internal state of ADPCM decoder 4 does not coincide with that of the ADPCM encoder of the counterpart so that prediction operation of ADPCM decoder 4 cannot maintain continuity, temporarily causing an abnormal sound (noises) upon a change-over of the switch of the reproduction mode.

Furthermore, in supplying an ADPCM code stored in memory 8 as reproduced speech to the counterpart, coincidence in internal state between ADPCM encoder 3 and ADPCM decoder 4 of the counterpart decays similarly at signal change-over and noises are temporarily generated at the counterpart.

A PCM code from PCM encoder 2 or PCM code 104 from ADPCM decoder 4 may be stored in memory 8 and a PCM code from memory 8 may be converted into an analog speech signal by PCM decoder 5 for recording and reproduction. In this example, however, the amount of data of speech information to be stored in memory 8 becomes enormous (since it is not compressed), and memory capacity of memory 8 and hence the price and scale of the devices are undesirably increased.

From US 5 195 128 a communication system, particularly a telephone communication system is known. The communication system has a controller and a first central memory that accepts messages, particularly voice messages. Instead of a separate tone means that forms user prompting/alerting tone signals and/or control information signals for message exchange protocols, the first central memory forms the tone means and contains stored alerting tone signals and/or control information signals for message exchange protocols.

It is an object of the present invention to provide a speech encoder/decoder with speech recording and reproduction functions operable with reduced occupying area and reduced power consumption, furthermore it is a specific object of the present invention to provide a speech encoder/decoder with speech recording and reproduction functions in which an ADPCM encoder/decoder can be used for both speech recording and reproduction and communication without generating noise.

This object is solved by a speech encoder/decoder with speech recording and reproduction functions having the features of claim 1. This object is also solved by a method of operating a speech encoder/decoder with the features of claim 6.

Preferred developments of the invention are given in the respective subclaims.

When the source of reproduced speech changes, that is, when the normal communication mode is switched to the reproduction mode and when the reproduction mode returns to the normal mode, the ADPCM decoder has its output muted and accordingly the magnitude of a PCM code from the ADPCM decoder is reduced, so that generation of noises at mode change-over is suppressed.

Outputs of the ADPCM decoder are easily muted by resetting the ADPCM decoder.

Furthermore in a switching mode, a reproduced code value of the ADPCM decoder can be reduced by applying an ADPCM code having zero difference value to the ADPCM decoder for a predetermined time period.

Furthermore, if the transmission output change-over switch is configured to select one of a PCM code from the ADPCM decoder and a PCM code from the PCM encoder and supply the selected PCM code to the ADPCM encoder, an ADPCM code which is reproduced speech when the reproduced speech is transmitted is first decompressed into a PCM code by the ADPCM decoder and is then input into the ADPCM encoder. Thus, the ADPCM encoder at the transmitting side can be used continuously, (the ADPCM decoder of the counterpart continuously inputs ADPCM codes and no differentiation between reproduced speech and input speech is made) and hence coincidence in internal state between the ADPCM decoder of the counterpart and the ADPCM encoder at the transmitting side can be ensured and generation of noises at the counterpart when receiving reproduced speech can be suppressed. Furthermore, the memory stores compressed codes therein and the memory capacity is not increased.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 schematically shows the entire configuration of a speech encoder/decoder with recording and reproduction functions according to a first embodiment of the present invention.

Fig. 2 is a waveform diagram representing the operation of the speech encoder/decoder shown in Fig. 1.

Fig. 3 is a flow chart illustrating the operation of the speech encoder/decoder shown in Fig. 1.

Fig. 4 schematically shows the configuration of the ADPCM decoder shown in Fig. 1.

Figs. 5A and 5B show an example of the configuration of initialization elements in the ADPCM decoder.

Fig. 6A schematically shows the entire configuration of a speech encoder/decoder according to a second embodiment of the present invention, and Fig. 6B is a waveform diagram representing the operation of the speech encoder/decoder shown in Fig. 6A.

Fig. 7 is a flow chart illustrating the operation of the speech encoder/decoder shown in Fig. 6A.

Fig. 8A schematically shows the configuration of a speech encoder/decoder according to a third embodiment of the present invention, and Fig. 8B is a flow chart illustrating the operation thereof.

Fig. 9A shows the configuration of a speech encoder/decoder according to a fourth embodiment of the present invention, and Fig. 9B is a flow chart illustrating the operation thereof.

Fig. 10 schematically shows the configuration of a conventional speech encoder/decoder with recording and reproduction functions.

Fig. 11A schematically shows the configuration of the ADPCM encoder shown in Fig. 10, and Fig. 11B schematically shows the configuration of the ADPCM decoder shown in Fig. 10.

DESCRIPTION OF THE PREFERRED EMBODIMENTS

(First Embodiment)

Fig. 1 schematically shows the entire configuration of a speech encoder/decoder with recording and reproduction functions according to a first embodiment of the present invention. In Fig. 1, the speech encoder/decoder with recording and reproduction functions includes a PCM encoder 2 for converting an analog speech signal 100 input from a microphone 1 into a PCM code 101, an ADPCM encoder 3 for compressing PCM code 101 from PCM encoder 2 into an ADPCM code 102 to output it on transmission line 102a, a recording input change-over switch 17 for selecting one of an ADPCM encoder 103 supplied on a receiving line 103a and ADPCM code 102 from ADPCM encoder 3 according to a recording input switching signal (i.e., a recording mode specifying signal) 111, a memory 8 for storing therein an ADPCM code 119 supplied from recording input change-over switch 17, a reproduction output change-over switch 18 for selecting one of an ADPCM code 120 read out from memory 8 and ADPCM code 103 supplied from receiving line 103a according to a reproduction mode signal (i.e., a reproduction mode specifying signal) 112, an ADPCM decoder 4 for decompressing an ADPCM code 121 supplied from reproduction output change-over switch 18 into a PCM code 104, a PCM decoder 5 for converting PCM code 104 from ADPCM decoder 4 into an analog speech signal 105, and a speaker 11 for outputting analog speech signal 105 from PCM decoder 5.

PCM encoder 2 samples and converts analog speech signal 100 into a digital signal, and encodes each sampled digital signal. The configuration of ADPCM encoder 3 is the same as that shown in Fig. 11A. ADPCM encoder 3 adaptively performs differential prediction for PCM code 101 and quantizes the difference between the prediction value and the PCM code 101 to generate ADPCM code 102.

Transmission line (referred to as a transmitting terminal hereinafter) 102a and receiving line (referred to as a receiving terminal hereinafter) 103a configures a transmission line, and may be coupled to a wire communication channel or may be coupled to an antenna for wireless transmission.

ADPCM decoder 4, the configuration of which will be described in detail later, performs the processing of the reverse to processes in encoding processing on an ADPCM code supplied from reproduction output change-over switch 18 to generate a PCM code. PCM decoder 5 receives the PCM code 104, performs the processing reverse to that in PCM encoder 2 to generate a digital signal, and then converts the digital signal into an analog signal to generate analog speech signal 105.

When recording input switching signal 111 designates recording of speech signals, recording input change-over switch 17 selects ADPCM code 102 from ADPCM encoder 3. On the other hand, when recording input switching signal 111 designates recording of signals transmitted from the counterpart, recording input change-over switch 17 selects ADPCM code 103 supplied via the transmission line to receiving terminal 103a. ADPCM code 119 supplied from recording input change-over switch 17 is stored in memory 8.

When reproduction mode signal 112 designates reproduction of signals transmitted from the counterpart, that is, when it designates the normal communication mode, reproduction output change-over switch 18 selects ADPCM code 103 supplied from receiving terminal 103a. On the other hand, when reproduction mode signal 112 designates reproduction of speech signals stored in memory 8, reproduction output change-over switch 18 selects ADPCM code 120 read from memory 8.

The speech encoder/decoder with recording and reproduction functions further includes a reset signal generating circuit 19 which generates a one shot reset signal 122 in response to a change in reproduction mode signal 112 for application to ADPCM decoder 4. Reset signal generating circuit 19 generates one shot reset signal 122 at change over from the normal communication mode to the reproduction mode and vice versa. ADPCM decoder 4 has its internal circuitry reset (as to this state, a detailed description will be provided later) and ADPCM decoder 4 has its output muted.

The speech encoder/decoder further includes a controller 150 responsive to operation signals input by an operator for controlling writing into and reading from memory 8 and for generating recording input switching signal 111 and reproduction mode signal 112. Controller 150 is typically configured by a microcomputer. Fig. 2 is a waveform diagram illustrating the operation of the speech encoder/decoder with recording and reproduction functions shown in Fig. 1. Now, the operation of the speech encoder/decoder shown in Fig. 1 will be described with reference to Fig. 2.

When reproduction mode signal 112 indicates the normal communication mode to designate communication via the transmission line, reproduction output change-over switch 18 selects ADPCM code 103 supplied from the transmission line via receiving terminal 103a to supply it as an ADPCM code 121 to ADPCM decoder 4. Recording input change-over switch 17 may be at any state. This is because write operation of ADPCM code 119 into memory 8 is stopped under the control of controller 150. In this state, ADPCM decoder 4 receives ADPCM code 103 supplied from reproduction output change-over switch 18 as ADPCM code 121 for ADPCM decode processing, to generate and supply PCM code 104 to PCM decoder 5. PCM decoder 5 performs decoding processing on the PCM code supplied from ADPCM decoder 4 to generate and supply analog speech signal 105 to speaker 11.

On the other hand, PCM encoder 2 encodes analog speech signal 100 input from microphone 1 into a PCM code and supplies the PCM code 101 to ADPCM encoder 3. ADPCM encoder 3 compresses the PCM code 101 into ADPCM code 102 for transmission to transmitting terminal 102a.

In other words, in the normal communication mode, as conventional, speech encoding processing for converting analog speech signal 100 into ADPCM code 102 by PCM encoder 2 and ADPCM encoder 3, and speech decoding processing for converting a received ADPCM code 103 into analog speech signal 105 by ADPCM decoder 4 and PCM decoder 5 are performed.

Upon recording, an ADPCM code (code 102 or 103) selected by recording input switching signal 111 supplied from controller 150 is selected by recording input change-over switch 17 and stored in memory 8.

Upon shifting from the normal communication mode to the recording mode, reproduction mode signal 112 is set to a state which is similar to that in the normal communication mode (when communication is performed simultaneously). When only recording is performed, reproduction output change-over switch 18 may select either ADPCM code 103 or ADPCM code 120.

Upon switching from the normal communication mode to the reproduction mode, the state of reproduction mode signal 112 from controller 150 changes (in Fig. 2, it is shown changing from low (L) level to high (H) level and accordingly reproduction output change-over switch 18 is set to select ADPCM code 120 from memory 8. Furthermore, according to the change in state of reproduction mode signal 112, reset signal 122 from reset signal generating circuit 19 is activated to reset ADPCM decoder 4 and the internal state of ADPCM decoder 4 is initialized. By the resetting to the initial state, ADPCM decoder 4 has its output muted. After ADPCM decoder 4 is reset, ADPCM code 120 is read from memory 8 and supplied as ADPCM code 121 to ADPCM decoder 4 via reproduction output change-over switch 18.

The internal state of ADPCM decoder 4 does not coincide with that of the ADPCM encoder when ADPCM code 120 read from memory 8 is encoded. Therefore, an error of a prediction signal is increased in ADPCM decode processing. However, as ADPCM decoder 4 has its output muted by reset signal 122, noises caused by a series of discontinuous ADPCM codes (a series of ADPCM codes 103 on the receiving line and an ADPCM code read from memory 8) are not caused.

In ADPCM decoder 4, non-coincidence of its internal state (i.e., an error of a prediction signal) is gradually corrected by suppressing error propagation using leakage coefficients described later, and ADPCM decoder 4 supplies a PCM code precisely reproduced from an ADPCM code read from memory 8 as time elapses.

In Fig. 2, the state of ADPCM code 121 is shown being uncertain when reset signal 122 is generated. This indicates that reading from memory 8 needs not be done during this period.

Upon shifting from the reproduction mode to the normal communication mode also, the state of reproduction mode signal 112 changes (in Fig. 2, it changes from H level to L level) and reset signal generating circuit 19 generates reset signal 122. Accordingly, ADPCM decoder 4 is reset and its output is muted.

According to the reproduction mode signal 112, reproduction output change-over switch 18 selects ADPCM code 103 supplied from receiving terminal-103a and supplies it as ADPCM code 121 to ADPCM decoder 4. The internal state of ADPCM decoder 4 coincides with a state when ADPCM code 120 from memory 8 is encoded, and differs from an internal state when ADPCM code 103 newly supplied on the transmission line, causing discontinuities in a series of received ADPCM codes and hence those in a series of reproduced PCM codes.

In this state, however, ADPCM decoder 4 is also set such that its output is muted, and no noises are caused. The non-coincidence of the internal state is corrected by the leakage coefficients mentioned above and its internal state gradually approaches to the internal state when ADPCM code 103 is encoded, so that PCM code 104 precisely converted from ADPCM code 103 is obtained from ADPCM decoder 4.

Upon the shifting from the reproduction mode to the normal communication mode also, ADPCM code 121 supplied from reproduction output change-over switch 18 is shown being at an uncertain state for a predetermine time period. Reproduction output change-over switch 18 may switch its current by established connection path during this period.

Fig. 3 is a flow chart illustrating the operation of controller 150 shown in Fig. 1. Referring to Fig. 3, the operation of the controller shown in Fig. 1 will now be described below.

First, controller 150 determines whether there is a changing-over between the reproduction mode and the communication mode according to an operation signal input by an operator (step S1). When a mode change-over is designated, controller 150 switches the state of reproduction mode signal 112 to switch the current connecting path of reproduction output change-over switch 18. Reset signal generating circuit 19 generates reset signal 122 according to the switching of the connecting path of reproduction output change-over switch 18. Reproduction output change-over switch 18 may be configured such that its current connecting path is switched after reset signal generating circuit 19 generates reset signal 122, or a connecting path of the production output change-over switch may be switched simultaneously with a generation of reset signal 122.

Then, it is determined whether the mode changing-over is a changing-over from the normal communication mode to the reproduction mode (step S3). In changing-over from the normal communication mode to the reproduction mode, controller 150 starts reading of data from memory 8 (step S5). On the other hand, in changing-over from the reproduction mode to the normal communication mode, reading of ADPCM codes from memory 8 is stopped after the reset signal is generated (step S4). In this mode changing-over, ADPCM decoder 4 continuously performs decoding operation (except when it is reset).

Fig. 4 shows the configuration of ADPCM decoder 4 shown in Fig. 1 in detail. In Fig. 4, ADPCM decoder 4 includes an inverse adaptive quantizer 4a for generating a quantized differential signal dq (k) from an ADPCM code 121 (I (k)) and a quantization scale factor y (k), a reconstructed signal calculator 4b for generating a reconstructed signal sr (k) from a quantized differential signal dq (k) and a prediction signal se (k) to output it as a PCM code 104, and an adaptive predictor 4c for generating a prediction signal se (k) from a quantized differential signal dq (k) and a reconstructed signal sr (k). The signals are all sampled digital signals, and the bracketted letter k added to a signal indicates the time when the signal is sampled.

ADPCM decoder 4 also includes a quantization scale factor adaptation 4d for generating a quantization scale factor y (k) according to ADPCM code 121 (I (k)) and an adaptive speed control variable al (k), and a tone and transition detector 4g for generating speed variables tr (k) and td (k) according to a quantization scale factor y (k), ADPCM code 121 (I (k)), an adaptive coefficient a2 (k) from adaptive predictor 4c and a quantized differential signal dq (k) to apply then to adaptive predictor 4c and an adaptive speed control 4e. The operation of each portion will now be described.

Inverse adaptive quantizer 4a converts an input ADPCM code 121 (I (k)) into a quantized differential signal dq (k) using a quantization scale factor y (k). The input signal I (k) is a differential signal (i.e., a differential signal between a prediction signal se (k) and a quantized PCM signal si (k)) which is quantized and then encoded. In the adaptive quantizer, the differential signal is converted to a logarithm value where the logarithm base is two, and is then normalized by the scale factor y (k). That is, a value given by the expression below is quantized and then encoded into an ADPCM code I (k):

$$\log_2 (d(k))-y(k).$$

Inverse adaptive quantitizer 4a performs the inverse processing, that is, it performs scaling by a quantization scale factor y (k) supplied from quantization scale factor adaptation 4d and converts a scaled value from a logarithm value to an antilogarithm value to obtain a quantized differential signal dq (k).

Quantization scale factor adaptation 4d generates a scale factor y (k) according to an ADPCM code 121 (I (k)) and an adaptive speed control variable al (k). Quantization scale factor adaptation 4d adaptively provides a high speed scale factor and a low speed scale factor. The high speed scale factor yu (k) is for signals having differential signals demonstrate large variations, such as speech. The low speed scale factor yl (k) is for signals having differential signals demonstrate small variations, such as tone signals and voice frequency band data signals. The high speed scale factor yu (k) and the low speed scale factor yl (k) are obtained by the following equations, respectively:

$$yu\ (k) = (1-2^{-5}\ y\ (k) + 2^{-5} W[I\ (k)]$$

$$yl\ (k) = (1-2^{-6}\ yl\ (k-1) + 2^{-6} yu\ (k).$$

As coefficients such as $(1-2^{-5})$, $(1-2^{-6})$ are used, influence from the past is rendered finite in adaptation process. Therefore, even if propagation errors are caused, the internal states of the encoder and the decoder converges such that they coincide with each other. These coefficients are referred to as leakage (leak) coefficients. W [I] is a discrete function which takes a predetermined value according to an input I (k). A scale factor y (k) is obtained by the following equation using the high speed scale factor yu (k) and the low speed scale factor yl (k):

$$y\ (k) = a_L\ (k) \cdot yu\ (k-l) + [1-a_L\ (k)] \cdot yl\ (k-l).$$

In quantization scale factor adaptation 4d, the high speed scale factor yu and the low speed scale factor yl are reset to predetermined initial values (i.e., 544 and 34816), respectively, according to a reset signal 122 (R).

Adaptive speed control variable $a_L$ (k) from adaptive speed control 4e approaches to one (unity) for speech signals and zero for voice frequency band data and tone signals. The variable $a_L$ (k) is calculated from the changing speed of a differential signal. Arithmetic processing in adaptive speed control 4e is expressed by the following equations. Two kinds of values indicating the mean value of the magnitude of a code I (k) are calculated:

$$dms\ (k) = (1-2^{-5}) \cdot dms\ (k-1) + 2^{-5} F[I\ (k)]$$

$$dml\ (k) = (1-2^{-7}) \cdot dml\ (k-1) + 2^{-7} F[I\ (k)].$$

The function F [I (k)] is a function which takes a predetermined discrete value. The dms (k) is the mean value of F [I (k)] for a relatively short period, and dml (k) is the mean value of the functional value F [I (k)] for a relatively long period. A variable ap (k) is defined using the two kinds of mean values dms (k) and dml (k):

(i) when I dms (k) -dml (k) I $\geqq 2^{-3}$ dml(k),

$$ap\ (k) = (1-2^{-4}) \cdot ap\ (k-1) + 2^{-3}$$

(ii) when y (k) < 3,

$$ap\ (k) = (1-2^{-4}) \cdot ap\ (k-1) + 2^{-3}$$

(iii) when td (k) = 1,

$$ap\ (k) = (1-2^{-4}) \cdot ap\ (k-1) + 2^{-3}$$

(iv) when tr (k) = 1,

$$ap\ (k) = 1;$$

(v) and otherwise,

$$ap\ (k) = (1-2^{-4}) \cdot ap\ (k-1).$$

The variable ap (k) approaches to two when there is a large difference between the mean values dms (k) and dm1 (k) (i.e., when the mean value in magnitude of I (k) is greatly changing), and it approaches to zero when there is a small difference between them (i.e., when the mean value of magnitude of I (k) is relatively constant). Y (k) > 3 means that communication using an empty channel is performed and the variable ap (k) approaches to two. For narrow-band signals, as described later, td (k) = 1 while the variable ap (k) approaches to two. When a change in a narrow-band signal is detected (tr (k) = 1), the variable ap (k) is set to one. An adaptive speed control variable $a_L$ (k) is obtained from a variable ap (k-1):

$$a_L\ (k) = 1 : ap\ (k-1) > 1,$$

$$a_L\ (k) = ap\ (k-1) : ap\ (k-1) \leqq 1.$$

By controlling through the variable $a_L$ (k), shifting of the adaptive speed from a fast state to a slow state is delayed until the absolute value of an input signal I (k) becomes constant, so that the adaptive rate is prevented from inadvertently shifting from a fast adaptive state to a slow adaptive state even when a pulse-form input signal is received.

In adaptive speed control 4e, according to generation of reset signal 122 (R), ap (k) is initialized to 0 and the mean values dms (k) and dml (k) are both set to 0's. Accordingly, the adaptive speed control variable $a_L$(k) is also reset to an initial value 0 by the resetting of the coefficients ap (k), dms (k) and dml (k). That is, the adaptive speed is delayed (i.e., due to the reset value, the high speed scale factor is invalidated and the scale factor y (k) is provided by the low speed scale factor yl (k)).

Adaptive predictor 4c calculates a prediction signal se (k) from a quantized differential signal dq (k). Two kinds of adaptive predictions are performed in adaptive predictor 4c. The prediction signal se (k) is calculated by the following equation:

$$se\ (k) = \Sigma ai\ (k-1) \cdot sr\ (k-i) + sez\ (k)$$

where the total summation is made for i = 1 and 2.

Sez (k) is obtained by the following equation:

$$sez\ (k) = \Sigma bi\ (k-1) \cdot dq\ (k-i)$$

where the total summation is made for i = 1 to 6.

The reproduction signal sr (k) is defined by the following equation:

$$sr\ (k-i) = se\ (k-i) + dq\ (k-i).$$

Coefficients a1 (k) and a2 (k) are obtained by the following equations, respectively:

$$a1\ (k) = (1-2^{-8}) \cdot a1\ (k-1)$$
$$+ (3 \cdot 2^{-8}) sgn\ [p\ (k)] \cdot sgn\ [p\ (k-1)]$$

$$a2\ (k) = (1-2^{-7}) \cdot a2\ (k-1)$$
$$+ 2^{-7} \{sgn\ [p\ (k)] \cdot sgn\ [p\ (k-2)]$$
$$-f\ [a1\ (k-1)] \cdot sgn\ [p\ (k)] \cdot sgn\ [p\ (k-1)]\}$$

where p (k) = dq (k) + sez (k).

Furthermore,

$$f\ (a1) = 4a1;\ |a1| \leqq 2^{-1}$$

$$f\ (a1) = 2 \cdot sgn\ (a1);\ |a1| > 2^{-1}$$

where sgn [p (k)] is the sign of p (k).

It is assumed that when tl (k) = 1, a1 (k) = a2 (k) = 0.

In the other prediction, bi (k) is given by the following equation:

$$bi\ (k) = (1-2^{-8}) \cdot bi\ (k-1)$$
$$+ 2^{-7} sgn\ [dq\ (k)] \cdot sgn\ [dq\ (k-i)]$$

where i = 1, 2, ..., 6

It is assumed that a coefficient b1 (k) = b2 (k) = ... = b6 (k) = 0 when tr (k) = 1. When reset signal 122 (R) is applied to reproduction signal calculating portion 4b, reproduction signals sr (k-1) and sr (k-2) are reset to a predetermined value, 32.

In adaptive predictor 4c, according to reset signal 122 (R), coefficients b1 (k-1) to b6 (k-1) are reset to 0's, coefficients a1 (k-1) and a2 (k-1) are reset to 0's, ap (k-1) is also reset to 0, and accordingly coefficients $a_L$ (k) is reset to 0.

Furthermore, in adaptive predictor 4c, the variables p (k-1) and p (k-2) are reset to a predetermined value, i.e., 0. Furthermore, quantized differential signals dq (k-1) to dq (k-6) are reset to a predetermined value, i.e., 32.

In tone and transition detector 4g, the adaptive speed of the quantizer is shifted to a fast state, when narrow-band signals such as tone signals and voice frequency band data signals are detected. That is:

when a2 (k) < -0.71875,

td (k) = 1,

and otherwise,

td (k) = 0.

Furthermore when a change in the detected narrow-band signal is detected, variables a1 and a2 and bi (k) in adaptive predictor 4c are all set to 0. That is:

when a2 (k) < -0.71875 and |dq (k)| >24·2·exp (yl (k)),

tr(k) = 1, and otherwise,

tr (k) = 0.

The specific configuration of ADPCM decoder 4 shown in Fig. 4 is described in detail in ITU Recommendation G 726. In the configuration shown in Fig. 4, by resetting each internal state to an initial value according to reset signal 122 (R), a reconstructed signal sr (k) has its amplitude value reduced and is muted. The differential signal dq (k-i) is reset to a predetermined value (i.e., 32) and the reconstructed signals sr (k-1) and sr (k-2) are also reset to the predetermined value of 32, and accordingly the signal sez (k) is reset to 0 (the coefficients bi (k-1) are all 0's) and the error signal (the prediction signal) se (k) is also reset to 0. Thus, the reconstructed signal sr (k) is reset to 0.

When the input of the ADPCM decoder is switched, the coefficients, or the internal state of each portion, are all set to initial values. Thus, a precise prediction signal se (k) for an ADPCM code newly read from memory 8 or an ADPCM code supplied on the transmission line is not calculated immediately. However, since error propagation is prevented by the leakage coefficient appended to each coefficient and since the internal state (the values of the coefficients) of ADPCM decoder 4 changes according to a newly supplied signal at a high speed due to a faster adaptive rate at the time of resetting to initial state, a precise reconstructed signal sr (k) is come to be generated according to an input signal I (k) in a short time period.

Specifically, in the configuration in which an internal state is reset to the initial state, the internal state may be reset to the initial state by software. However, when the resetting is implemented by hardware, reset elements may be provided for each predetermined bit since multibit operations is performed as internal operations. That is, as shown in Fig. 5A, when the reset value is 0, an n channel MOS transistor NQ which conducts according to a reset signal R is provided to discharge its output node to the ground potential level. On the other hand, when the reset value is 1, a p channel MOS transistor PQ which conducts according to an inverted signal /R of the reset signal R is provided to transfer a voltage at a power supply level VCC to its output node, as shown in Fig. 5B. Thus, when the reset signal is activated, the bit value of 1 is output. Reset values having a predetermined pattern can be easily implemented by hardware, by providing the reset elements shown in Figs. 5A and 5B for each bit.

As described above, according to the first embodiment of the present invention, since the internal state of the ADPCM decoder is reset upon mode change-over, the ADPCM decoder has its output muted upon the mode changing-over. Thus, even if a series of discontinuous ADPCM codes is supplied in a mode change-over, the mode can be switched without causing noises.

[Second Embodiment]

Fig. 6A shows the configuration of a speech encoder/decoder with recording and reproduction functions according to a second embodiment of the present invention. In Fig. 6A, the speech encoder/decoder includes a reproduction output code change-over switch 20 connected between a memory 8 and a reproduction output change-over switch 18 for selecting one of an ADPCM code 120 from memory 8 and an ADPCM code 123 for a fixed value of a differential value of the smallest absolute value such as difference zero according to a reproduction output code switching signal 124 from timer 21 to supply the selected ADPCM code to reproduction output change-over switch 18. Timer 21 sets reproduction output code change-over switch 20 to select ADPCM code 123 for the fixed value (i.e., the minimum absolute differential value) for a predetermined time period according to a reproduction mode signal 112a.

Reproduction output change-over switch 18 switches the current connection path according to a reproduction mode signal 112b. A controller 152 is responsible for reading/writing of code data from/into memory 8, generation of reproduction mode signal 112 (112a, 112b), and generation of recording input switching signal 111. The configurations of the other portions are the same as those in the first embodiment shown in Fig. 1 and the corresponding portions are labeled by the identical reference characters and the descriptions thereof are not repeated. Referring to Fig. 6B, the operation of the speech encoder/decoder according to the second embodiment shown in Fig. 6A will now be described.

In the normal communication mode, similarly to the first embodiment, reproduction output change-over switch 18 selects ADPCM code 103 supplied via receiving terminal 103a according to reproduction mode signal 112b and supplies it to ADPCM decoder 4. Timer 21 is not operated. Furthermore, an operation of writing into reading from memory 8 is stopped. In this state, speech encoding processing by PCM encoder 2 and ADPCM encoder 3 is applied to analog speech signal 100 which in turn is encoded into an ADPCM code, and speech decoding processing by ADPCM decoder 4 and PCM decoder 5 is applied to ADPCM code 103 supplied on the transmission line in order to restore an analog speech signal.

In recording, similarly to the first embodiment, according to recording input switching signal 111 from controller 152, one of ADPCM code 102 from ADPCM encoder 3 and ADPCM code 103 supplied on the transmission line is selected by recording input change-over switch 17 and stored into memory 8. When a normal communication is performed simultaneously, reproduction output change-over switch 18 selects ADPCM code 103 supplied on the transmission line via receiving terminal 103a and supplies it to ADPCM decoder 4. It is determined by an operation signal applied to controller 152 whether the ADPCM code transmitted is input to memory 8 or analog speech signal 100 from microphone 1 is encoded into an ADPCM code and input into memory 8 during the recording.

When the normal communication mode is shifted to the reproduction mode, reproduction mode signals 112 (112a and 112b) are both set to instruct the reproduction mode under the control of controller 152 and reproduction output change-over switch 18 is set to select a new code from reproduction output code change-over switch 20. Furthermore, timer 21 is started according to reproduction mode signal 112a, and sets reproduction output code change-over switch 20 to select ADPCM code 123 for a differential value of the smallest absolute value such as difference zero (referred to as "a minimum absolute differential value" hereinafter) for a predetermined time period (in Fig. 6B, an output 124 of timer 21 is shown being at H level in this state). Thus, ADPCM decoder 4 receives the ADPCM code of difference zero via switches 20 and 18 for decoding processing. In ADPCM decoder 4, the ADPCM code for the minimum absolute differential value of difference zero does not correspond to the internal state of ADPCM decoder 4.

As described hereinbefore, a reproduction signal sr (k) is generated from summation of a prediction signal se (k) and a differential signal dq (k). Since ADPCM decoder 4 has been supplied with the ADPCM code for the minimum absolute differential value, the quantized differential signal dq (k) is or approximates to 0 while output signal 124 of timer 21 is generated (i.e., during the periods at H level shown in Fig. 6B). The value of the prediction signal se (k) is gradually reduced by adaptive prediction, and consequently the value of the reproduction signal sr (k) is gradually reduced and ADPCM decoder 4 has its output muted. When ADPCM decoder 4 is supplied with the ADPCM code 123 for the minimum absolute differential value via switches 20 and 18, non-coincidence in internal state is caused in ADPCM decoder 4. However, since the input I (k) is the minimum absolute differential value, the prediction signal for the immediately previous reproduction signal is reproduced so that the discontinuity is small. Then, as described in the first embodiment, the reproduction signal value is reduced by the leakage coefficients and the non-coincidence is dissolved.

After ADPCM decoder 4 has its output muted, timer 21 completes its operation and reproduction output code change-over switch 20 is set to select ADPCM code 120 read from memory 8. ADPCM code 120 read from memory 8 is supplied to ADPCM decoder 4 via switches 20 and 18. ADPCM decoder 4 converts the ADPCM code from memory 8 into PCM code 104 without generating noises even when discontinuities are caused in the internal state of ADPCM decoder 4, since ADPCM decoder 4 has its output muted.

In this state also, the internal state of ADPCM decoder 4 does not coincide with that corresponding to the state of ADPCM code 120 read from memory 8. However, similarly to the first embodiment, the internal state of ADPCM decoder 4 gradually approaches to a state corresponding to ADPCM code 120 read from memory 8 by the effect of the leakage coefficients, and ADPCM code 120 from memory 8 is precisely converted to PCM code 104. PCM decoder 5 converts PCM code 104 into analog speech signal 105 and supplies it to speaker 11. Thus,-in the reproduction mode of operation, analog speech signal 105 corresponding to ADPCM code 120 from memory 8 is reproduced.

When the reproduction mode is shifted to the normal communication mode, firstly reproduction mode signal 112a is activated under the control of controller 152, and according to an output signal from timer 21, reproduction output code change-over switch 20 selects ADPCM code 123 for the minimum absolute differential value instead of ADPCM code 120 from memory 8 and supplies it to switch 18. In the reproduction mode, reproduction output change-over switch 18 has selected and supplied ADPCM code 125 supplied from switch 20 to ADPCM decoder 4. Thus, in this state, ADPCM decoder 4 is set such that its output is muted according to ADPCM code 123 for the minimum absolute differential value.

When the output of ADPCM decoder 4 is set to be muted, reproduction mode signal 112b is then output from controller 152 and reproduction output change-over switch 18 selects ADPCM code 103 supplied via the transmission line to receiving terminal 103a and supplies it to ADPCM decoder 4. ADPCM decoder 4 decodes the transmitted ADPCM code 103 instead of ADPCM code 123 for the minimum absolute differential value. A discontinuity is caused in the internal state of ADPCM decoder 4 while ADPCM decoder 4 decodes the transmitted ADPCM code 103 to generate PCM code 104 without causing noises, since ADPCM decoder 4 has its output muted. Thus, speech signals are output from speaker 11 with analog speech signal 105 from PCM decoder 5 free from noises.

In the operation waveforms shown in Fig. 6B, reproduction mode signal 112b is shown such that its state changes when output signal 124 of timer 21 is inactivated. However, reproduction mode signal 112b need not synchronize with changes of output signals from timer 21, and the state of reproduction mode signal 112b may change when ADPCM decoder 4 has its output muted.

Fig. 7 is a flow chart illustrating the operation of controller 152 according to the second embodiment of the present invention. Now, referring to Fig. 7, the operation of controller 152 shown in Fig. 6A will be described.

Controller 152 determines whether change-over between the normal communication mode and the reproduction mode is designated according to an operation signal from an operator (step S10). When no mode change-over is designated, the current state is maintained.

On the other hand, when a mode change-over is designated, controller 152 generates reproduction mode signal 112a to start timer 21. Accordingly, reproduction mode change-over switch 20 is set to select ADPCM code 123 for the minimum absolute differential value (step S11).

Then, it is determined whether the mode change-over is a change-over from the normal communication mode to the reproduction mode. When it is determined that the communication mode is switched to the reproduction mode, controller 152 generates reproduction mode signal 112b to set reproduction output change-over switch 18 to select a code output from reproduction code change-over switch 20 (step S13). Thus ADPCM decoder 4 is set to decode ADPCM code 123 for the minimum absolute differential value, and ADPCM decoder 4 has its output muted (step S15). When a predetermined period elapses, the operation of timer 21 is stopped (step S17). Reproduction code change-over switch 20 is set to select ADPCM code 120 from memory 8. Then, controller 152 reads an ADPCM code from memory 8 and supplies it to switch 20. Thus, the ADPCM code stored in memory 8 is supplied to ADPCM decoder 4 via switches 20 and 18 for decoding processing (S19).

On the other hand, when it is determined that the reproduction mode is switched to the communication mode in step S12, reproduction mode signal 112b has not yet been generated. In the reproduction mode, reproduction output change-over switch 18 has been set to select an ADPCM code from reproduction output code change-over-switch 20. Thus, reproduction output change-over switch 18 selects ADPCM code 123 for the minimum absolute differential value supplied from reproduction output code change-over switch 20 and supplies it to ADPCM decoder 4. When the predetermined period elapses, the operation of timer 21 is stopped and reproduction mode signal 112b is further generated so that reproduction output change-over switch 18 is set to select ADPCM code 103 supplied via transmitting terminal 103a.

Thereafter, when step S19 and step S16 are completed, ADPCM decoder 4 decodes ADPCM code 126 supplied thereto.

ADPCM code 123 for a fixed value may be any value as long as it mutes the output of ADPCM decoder 4, and it may be a fixed value of a sufficiently small absolute value which is not necessarily be zero difference.

In the second embodiment also, as described above, since ADPCM decoder 4 is set such that its output is muted by applying an ADPCM code for a fixed value of the minimum absolute differential value to ADPCM decoder 4, generation of noises at mode change-over can be suppressed.

Furthermore, similarly to the first embodiment, ADPCM encoder 3 and ADPCM decoder 4 can be used for speech encoding processing in the communication mode. Furthermore, ADPCM encoder 3 and ADPCM decoder 4 can be used in recording into and reproducing from memory 8. Thus, a speech encoder/decoder which does not generate noises and has a smaller number of circuit components can be implemented.

(Third Embodiment)

Fig. 8A schematically shows the configuration of a speech encoder/decoder with recording and reproduction functions according to a third embodiment of the present invention. In Fig. 8A, the speech encoder/decoder includes a transmission output change-over switch 22 connected between PCM encoder 2 and ADPCM encoder 3 for selecting one of PCM code 101 from PCM encoder 2 and PCM code 104 from ADPCM decoder 4 according to a transmission output switching signal 128. Transmission output switching signal 128 is generated from a controller 154 according to an operation signal which is input by an operator. The configurations of the other portions are the same as those of the first embodiment shown in Fig. 1, and the corresponding portions are labeled by the identical reference characters and the description thereof is not repeated.

Fig. 8B is a flow chart illustrating the operation of the speech encoder/decoder shown in Fig. 8A. Now, referring to Figs. 8A and 8B, the operation of the speech encoder/decoder according to the third embodiment of the present invention will be described.

In the normal communication mode and the recording mode, the operations are the same as those in the first embodiment. Furthermore, similarly to the first embodiment, if ADPCM code 120 from memory 8 is reproduced upon a mode change-over, ADPCM decoder 4 is reset by reset signal 122 from reset signal generating circuit 19 and has its output muted, so that switching between the normal mode and the reproduction mode can be achieved without causing noises. The following steps are added in the reproduction mode in the embodiment 3.

That is, it is determined in step S3 shown in Fig. 3 whether there has been a change-over from the communication mode to the reproduction mode, and according to the decision, ADPCM code 120 is read out from memory 8 and supplied to ADPCM decoder 4 (step S5). Then, controller 154 determines whether PCM code 104 from ADPCM decoder 4 is transmitted according to an applied operation signal (step S20). When it is determined that ADPCM code 120 read from memory 8 is reproduced and transmitted to the counterpart, controller 154 generates transmission output switching signal 128 to set transmission output change-over switch 22 to select PCM code 104 (step S22). In this state, firstly ADPCM code 120 read from memory 8 is supplied to ADPCM decoder 4 via the switch 18 and converted to PCM code 104. The PCM code 104 is supplied to ADPCM encoder 3 via the switch 22 and converted to ADPCM code 102. The ADPCM code 102 is transmitted to the counterpart via transmitting terminal 102a. ADPCM encoder 3 is successively encoding PCM codes. Therefore, the internal state of ADPCM encoder 3 at the transmitting side successively changes according to the supplied PCM codes 127 so that the internal state of ADPCM decoder 4 of the counterpart coincides with that of ADPCM encoder 3 of the transmitting side. Thus, an ADPCM code read from memory 8 can be reproduced and transmitted to the counterpart without causing noises at the counterpart.

In Fig. 8B, steps S5 and S20 may be exchanged with each other. Furthermore in the flow chart shown in Fig. 8B, the remaining steps are the same as those in the flow chart shown in Fig. 3.

As described above, according to the third embodiment of the present invention, as PCM codes from ADPCM decoder 4 are selectively supplied to ADPCM encoder 3 in addition to the configuration of the first embodiment, ADPCM codes reproduced from memory 8 can be reproduced and transmitted to the counterpart without generating noises at the counterpart.

(Fourth Embodiment)

Fig. 9A schematically shows the configuration of a speech encoder/decoder with recording and-reproduction functions according to a fourth embodiment of the present invention. In Fig. 9A, the speech encoder/decoder includes a transmission output change-over switch 22 for selecting one of PCM code 104 from ADPCM decoder 4 and PCM code 101 from PCM encoder 2 under the control of a controller 156 and supplying the selected PCM code to ADPCM encoder 3, in addition to the configuration of the speech encoder/decoder shown in Fig. 6A. Transmission output change-over switch 22 has its connecting path set by transmission output switching signal 128 applied from controller 156. Controller 156 generates a required control signal according to an operation signal supplied by an operator. The configurations of the other portions are the same as those shown in Fig. 6A, and the corresponding portions are labeled by the identical reference characters and the descriptions thereof are not repeated.

In the normal communication mode and the recording mode, the operations are similar to those in the second embodiment. Since ADPCM code 123 for a fixed value of the minimum absolute differential value is supplied to ADPCM decoder 4 according to signal 124 from timer 21 upon switching between the reproduction mode and the normal mode, mode changing-over without generating noises can be achieved at a change-over between the normal mode and the reproduction mode. This is because the same operation as that in the second embodiment is carried out.

Referring to the flow chart shown in Fig. 9B, the operation will now be described in which a PCM code 104 reproduced by ADPCM decoder 4 from ADPCM code 120 read from memory 8 is transmitted to the counterpart. In this flow chart, operations similar to those shown in the flow chart shown in Fig. 7 are performed, and step S17 shown in Fig. 7 is followed by the following operations in accordance with the fourth embodiment.

First, it is determined whether a reproduced code should be transmitted to the counterpart upon a change-over from the normal communication mode to the reproduction mode, following or simultaneously with step S17 (step S25). When a decision is made that the reproduced speech is to be transmitted to the counterpart, controller 156 generates transmission output switching signal 128 to set transmission output change-over switch 22 to select PCM code 104 from ADPCM decoder 4 (step S26). Then, an ADPCM code is read from memory 8 (step S19). When transmission to the counterpart is performed in parallel with the read operation, PCM code 104 from ADPCM decoder 4 is again converted to an ADPCM code by ADPCM encoder 3 and is transmitted to the counterpart via a transmitting terminal 102a. In this state, since ADPCM code 102 has been generated by ADPCM encoder 3, the internal state of the ADPCM decoder 4 of the counterpart coincides with that of ADPCM encoder 3 at the transmitting side. Thus, the counterpart can receive and reproduce the reproduced speech code from memory 8 without generating noises.

In the flow chart shown in Fig. 9B, step S25 may be performed earlier than or simultaneously with step S17 shown in Fig. 7. The decision at step S25 may be made simultaneously with step S12 shown in Fig. 7.

As described above, according to the fourth embodiment of the present invention, an ADPCM for the minimum absolute differential value is transferred to ADPCM decoder 4 under the control of timer 21 to mute the output of ADPCM decoder 4, and PCM code 104 output from ADPCM decoder 4 is supplied to ADPCM encoder 3 via the switch 22 to send ADPCM code 102 to the counterpart. Thus, mode change-over without generating noises can be achieved when the communication mode is switched to the reproduction mode and vice versa. At the counterpart also, speech can be reproduced without generating noises even when the received speech data is switched to reproduced speech data from memory 8.

In the fourth embodiment also, similar to the second embodiment, ADPCM encoder 3 and ADPCM decoder 4 can be used for both the communication mode and the recording/reproduction mode so that power consumption and the number of components can be reduced and a device which occupies a smaller area can be implemented.

While an ADPCM encoder/decoder has been described as a speech encoder and a speech decoder of a speech encoder/decoder with recording and reproduction functions in the above embodiments, the present invention is also applicable to a speech encoder/decoder along other highly efficient encoding system.

A switching signal for each switch may be directly applied from the external.

Furthermore, when the operational processings of a digital signal processor (DSP) are implemented by firmware, the speech encoder/decoder with recording and reproduction functions of the present invention allows reduction in scale of the firmware, as the encoder/decoder is commonly used, whereby the memory size, for example, of an ROM for storing the firmware therein can be reduced.

As described above, according to the present invention, as ADPCM decoder 4 has its output muted upon switching between the normal communication mode and the reproduction mode, a pair of an ADPCM encoder and an ADPCM decoder can be used for both the speech recording/reproduction function and the speech encoding/decoding function for communication, the scale of hardware can be reduced and hence a speech encoder/decoder with speech recording and reproduction functions with reduced power consumption can be obtained.

Although the present invention has been described and illustrated in detail, it is clearly understood that the same is by way of illustration and example only and is not to be taken by way of limitation, the scope of the present invention being limited only by the terms of the appended claims.

## Claims

**1.** A speech encoder/decoder with speech recording and reproduction functions, comprising:

a PCM encoder (2) for converting an input analog speech signal (100) into a first PCM code (101);
an ADPCM encoder (3) for compressing the first PCM code (101) supplied from said PCM encoder (2) into a first ADPCM code (102) and outputting the first ADPCM code (102);
an ADPCM decoder (4) for decompressing a supplied ADPCM code (121) into a second PCM code (104);
a PCM decoder (5) for converting the second PCM code (104) from said ADPCM decoder (4) into an analog speech signal (105) and outputting the analog speech signal (105);
a recording input select switch (17) for selecting one of an input ADPCM code (103) from a counterpart and the first ADPCM code (102) from said ADPCM encoder (3) according to a recording mode specifying signal (111);
a memory (8) for storing therein the ADPCM code (119) selected by and supplied from said recording input select switch (17);
a reproduction output select switch (18) for selecting one of said input ADPCM code (103) and the ADPCM code (120) read from said memory (8) according to a reproduction mode specifying signal (112) and supplying a selected ADPCM code to said ADPCM decoder (4); and
mute means (19; 20, 21) responsive to a change of said reproduction mode specify signal (112) for reducing a magnitude of the second PCM code (104) from said ADPCM decoder (4).

**2.** The speech encoder/decoder with speech recording and reproduction functions according to claim 1, wherein said mute means (19; 20, 21) includes a reset signal generating circuit (19) responsive to a change of said reproduction mode specifying signal (112) for applying a reset signal (122) to said ADPCM decoder (4) to reset said ADPCM decoder (4) to as initial state.

**3.** The speech encoder/decoder with speech recording and reproduction functions according to claim 1 or 2, wherein said mute means (19; 20, 21) includes:

timer means (21) responsive to a change of said reproduction mode specifying signal (112) for activating and outputting a select signal (124); and
a reproduction output code select switch (20) coupled to receive the ADPCM code (120) read from said memory means (8) and a predetermined ADPCM code for a fixed value of a differential value of the smallest absolute value for selecting said ADPCM code for said fixed value, for selecting and transmitting said predetermined ADPCM code, to said reproduction output select switch (18) in response to activation of said select signal (124).

**4.** The speech encoder/decoder with speech recording and reproduction functions according to one of claims 1 to 3, wherein said ADPCM decoder (4) has a coefficient used in ADPCM decoding processing reset to a predetermined initial value in response to said reset signal (122).

**5.** The speech encoder/decoder with speech recording and reproduction functions according to one of claims 1 to 4, further comprising a transmission output select switch (22) for selecting one of the first PCM code (101) from said PCM encoder (2) and the second PCM code (104) from said ADPCM decoder (4) according to a transmission output specify signal (128) to supply the selected PCM code to said ADPCM encoder (3).

**6.** A method of operating a speed encoder/decoder operable in a communication mode, a speech recording mode and a speech reproducing mode, comprising the steps of:

in said communication mode of operation performing a highly efficient coding process on an input analog speech signal to produce a highly, efficiently encoded speech data for transmission to a counterpart, and performing a highly efficient decoding process on a highly, efficiently encoded speech data supplied from said counterpart through a decoder (4, 5) to produce an analog speech signal for external outputting, in said recording mode of operation,-storing one of the internally produced highly, efficiently encoded speech data received from said counterpart into a memory (8);
in said reproducing mode of operation, reading the highly, efficiently encoded speed data from said memory to perform the highly, efficiently decoding processing on the read out speech data in said decoder, and,
in a switch between the communication mode of operation and the reproducing mode of operation and the reproducing mode of operation, attenuating said analog speech signal for external outputting.

**7.** The method according to claim 6, wherein said decoder (4, 5) includes as first decoder (4) for performing an adaptive differential decoding processing on a received highly, efficiently encoded speech data, and a second decoder (5) for further performing a non-adaptive decoding processing on the speech data received from said first decoder, to produce the analog speech signal and wherein the step of attenuating includes the step of resetting said first decoder to an initial state.

**8.** The method of according to claim 6, wherein said decoder (4, 5) includes a first decoder (4) for performing an adaptive differential decoding on the received highly, efficiently encoded speech data, and a second decoder (5) for further performing a non-adaptive decoding on the speech data decoded by and supplied from the first decoder, and wherein the step of attenuating includes the step of supplying a predetermined adaptive differential code for a smallest absolute differential value to said first decoder for a predetermined time period.

**9.** The method of according to one of claims 6 to 8, wherein the step of performing a highly efficient coding process includes the step of performing a PCM coding process on said input analog signal, and performing an adaptive differential coding process on the PCM coded speech signal to generate said highly, efficiently encoded speed data, and wherein the step of performing a highly, efficiently decoding process includes the step of performing an adaptive differential PCM decoding process on the received highly, efficiently encoded speech data, and further performing a non adaptive PCM decoding process on the speech data subject to the adaptive differential PCM decoding processing, and wherein said method further includes the step of selectively supplying the speech data subject to the adaptive differential PCM decoding process in place of the PCM coded speech signal.

## Patentansprüche

**1.** Sprachkodierer/-dekodierer mit Funktionen des Aufzeichnens und Reproduzierens von Sprache, mit:

einem PCM-Kodierer (2) zum Umwandeln eines analogen Eingangssprachsignales (100) in einen ersten PCM-Code (101);
einem ADPCM-Kodierer (3) zum Komprimieren des von dem PCM-Kodierers (2) gelieferten ersten PCM-Codes (101) in einen ersten ADPCM-Code (102) und Ausgeben des ersten ADCPM-Codes (102);
einem ADPCM-Dekodierer (4) zum Dekomprimieren eines gelieferten ADPCM-Codes (121) in einen zweiten PCM-Code (104);
einem PCM-Dekodierer (5) zum Umwandeln des zweiten PCM-Codes (104) von dem ADPCM-Dekodierer (4) in ein analoges Sprachsignal (105) und Ausgeben des analogen Sprachsignales (105);
einem Auswahlschalter (17) des Aufzeichnungsausganges zum Auswählen von einem von einem ADPCM-Code (103) von einem Gegenstück und dem ersten ADPCM-Code (102) von dem ADPCM-Dekodierer (3) gemäß einem Bestimmungssignal (111) des Aufzeichnungsmodus;
einem Speicher (8) zum Speichern des von dem Auswahlschalter (17) des Aufzeichnungseinganges ausgewählten und gelieferten ADPCM-Codes (119);
einem Auswahlschalter (18) des Reproduktionsausganges zum Auswählen von einem von dem Eingangs-ADPCM-Code (103) und dem aus dem Speicher (8) gelesenen ADPCM-Code (120) gemäß einem Bestimmungssignal (112) des Reproduktionsmodus und Liefern eines ausgewählten ADPCM-Codes an den ADPCM-Dekodierer (4); und
einem Dämpfungsmittel (19, 20, 21), das auf eine Änderung des Bestimmungssignales (12) des Reproduktionsmodus reagiert zum Verringern einer Größe des zweiten PCM-Codes (104) von dem ADPCM-Dekodierer (4).

**2.** Sprachkodierer/-dekodierer mit Funktionen des Aufzeichnens und Reproduzierens von Sprachen nach Anspruch 1, bei dem das Dämpfungsmittel (19; 20, 21) eine Rücksetzsignalerzeugerschaltung (19) aufweist, die auf eine Änderung des Bestimmungssignal (112) des Aufzeichnungsmodus reagiert zum Anlegen eines Rücksetzsignales (122) an den ADPCM-Dekodierer (4) zum Zurücksetzen des ADPCM-Dekodierers (4) zu einem Anfangszustand.

**3.** Sprachkodierer/-dekodierer mit Funktionen des Aufzeichnens und Reproduzierens von Sprache nach Anspruch 1 oder 2, bei dem das Dämpfungsmittel (19; 20, 21) aufweist:

ein Zeitgebermittel (21), das auf eine Änderung des Bestimmungssignales (112) des Reproduktionsmodus reagiert zum Aktivieren und Ausgeben eines Auswahlsignales (124); und
einen Codeauswahlschalter (20) des Reproduktionsausganges, der gekoppelt ist zum Empfangen des aus dem Speicher (8) gelesenen ADPCM-Codes (120) und eines vorbestimmten ADPCM-Codes für einen festen Wert eines Differentialwertes des kleinsten Absolutwertes zum Auswählen des ADPCM-Codes für den festen Wert, zum Auswählen und Übertragen des vorbestimmten ADPCM-Codes zu dem Auswahlschalter (18) des Reproduktionsausganges als Reaktion auf die Aktivierung des Auswahlsignales (124).

**4.** Sprachkodierer/-dekodierer mit Funktionen des Aufzeichnens und Reproduzierens von Sprache nach einem der Ansprüche 1 bis 3, bei dem der ADPCM-Dekodierer (4) einen Koeffizienten aufweist, der in der ADPCM-Dekodierverarbeitung benutzt wird, der auf einen vorbestimmten Anfangswert als Reaktion auf das Rücksetzsignal (122) zurückgesetzt wird.

**5.** Sprachkodierer/-dekodierer mit Funktionen des Aufzeichnens und Reproduzierens von Sprache nach einem der Ansprüche 1 bis 4, weiter mit einem Auswahlschalter (22) des Übertragungsausganges zum Auswählen eines von dem ersten PCM-Code (101) von dem PCM-Kodierer (2) und dem zweiten PCM-Code (104) von dem ADPCM-Dekodierer (4) gemäß eines Übertragungsausgangsbestimmungssignales (128) zum Liefern des ausgewählten PCM-Codes an den ADPCM-Kodierer (3).

**6.** Verfahren zum Betreiben eines Sprachkodierers/-dekodierers, der in einem Kommunikationsmodus, einem Sprachaufzeichnungsmodus und einem Sprachreproduktionsmodus betreibbar ist, mit den Schritten:

in dem Kommunikationsmodus des Betriebes Durchführen eines hochwirksamen Kodierungsvorganges auf einem analogen Eingangssprachsignales zum Erzeugen von hochwirksam kodierten Sprachdaten zur Übertragung zu einem Gegenstück und Durchführen eines hochwirksamen Dekodiervorganges auf hochwirksamen kodierten Sprachdaten, die von dem Gegenstück geliefert werden, durch einen Dekodierer (4, 5) zum Erzeugen eines analogen Sprachsignales zum externen Ausgeben,
in dem Aufzeichnungsmodus des Betriebes Speichern eines der intern erzeugten hochwirksam kodierten Sprachdaten, die von dem Gegenstück empfangen sind, in einen Speicher (8);
in dem Reproduktionsmodus des Betriebes Lesen der hochwirksam kodierten Sprachdaten von dem Speicher zum Durchführen der hochwirksamen Dekodierverarbeitung auf den ausgelesenen Sprachdaten in dem Dekodierer und in einem Schalter zwischen dem Kommunikationsmodus des Betriebes und dem Reproduktionsmodus des Betriebes und dem Reproduktionsmodus des Betriebes Dämpfen des analogen Sprachsignales für externe Ausgabe.

**7.** Verfahren nach Anspruch 6, worin der Dekodierer (4, 5) einen ersten Dekodierer (4) zum Durchführen einer adaptiven Differentialdekodierverarbeitung auf empfangenen hochwirksam kodierten Sprachdaten und einen zweiten Dekodierer (5) zum weiteren Durchführen einer nicht-adaptiven Dekodierverarbeitung auf den von dem ersten Dekodierer empfangenen Sprachdaten zum Erzeugen des analogen Sprachsignales aufweist und worin der Schritt des Dämpfens den Schritt des Zurücksetzen des ersten Dekodierers in einen Anfangszustand aufweist.

**8.** Verfahren nach Anspruch 6, worin der Dekodierer (4, 5) einen ersten Dekodierer (4) zum Durchführen einer adaptiven Differentialdekodierung auf den empfangenen hochwirksam kodierten Sprachdaten und einen zweiten Dekodierer (5) zum weiteren Ausführen einer nicht-adaptiven Dekodierung auf den Sprachdaten, die von dem ersten Dekodierer dekodiert werden und geliefert werden, aufweist, und worin der Schritt des Dämpfens den Schritt des Lieferns eines vorbestimmten adaptiven Differentialcodes für einen kleinsten Absolutdifferentialwert an den ersten Dekodierer während einer vorbestimmten Zeitdauer aufweist.

**9.** Verfahren nach einem der Ansprüche 6 bis 8, bei dem der Schritt des Durchführens eines hochwirksamen Kodiervorganges den Schritt des Durchführens eines PCM-Kodiervorganges auf dem analogen Eingangssignal und Durchführen eines adaptiven Differentialkodiervorganges auf dem PCM-kodierten Sprachsignal zum Erzeugen der hochwirksam kodierten Sprachdaten aufweist und worin der Schritt des Durchführens eines hochwirksam DekodierVorganges den Schritt des Durchführens eines adaptiven Differential-PCM-Dekodiervorganges auf den empfangenen hochwirksam kodierten Sprachdaten und weiter des Durchführens eines nicht-adaptiven PCM-Dekodiervorganges auf den Sprachdaten, die der adaptiven Differential-PCM-Dekodierverarbeitung unterworfen werden, aufweist und worin das Verfahren weiter den Schritt des selektiven Lieferns der Sprachdaten, die dem adaptiven Differential-PCM-Dekodiervorganges unterworfen werden, anstelle des PCM-kodierten Sprachsignales aufweist.

**Revendications**

**1.** Un codeur/décodeur de parole ayant des fonctions d'enregistrement et de reproduction de la parole, comprenant :

un codeur MIC (2) pour convertir un signal de parole analogique d'entrée (100) en un premier code MIC (101);
un codeur MIC-DA (3) pour compresser le premier code MIC (101) qui est fourni par le codeur MIC (2), de façon à donner un premier code MIC-DA (102), et pour fournir en sortie le premier code MIC-DA (102);
un décodeur MIC-DA (4) pour décompresser un code MIC-DA (121) qui lui est appliqué, pour donner un second code MIC (104);
un décodeur MIC (5) pour convertir le second code MIC (104) provenant du décodeur MIC-DA (4) en un signal de parole analogique (105), et pour fournir en sortie le signal de parole analogique (105);
un commutateur de sélection d'entrée d'enregistrement (17) pour sélectionner un code parmi un code MIC-DA d'entrée (103) provenant d'un interlocuteur et le premier code MIC-DA (102) provenant du codeur MIC-DA (3), conformément à un signal de spécification de mode d'enregistrement (111);
une mémoire (8) pour enregistrer à l'intérieur le code MIC-DA (119) qui est sélectionné par le commutateur de sélection d'entrée d'enregistrement (17) et qui est fourni par ce dernier;
un commutateur de sélection de sortie de reproduction (18) pour sélectionner un code parmi le code MIC-DA d'entrée (103) et le code MIC-DA (120) qui est lu dans la mémoire (8), conformément à un signal de spécification de mode de reproduction (112), et pour fournir un code MIC-DA sélectionné au décodeur MIC-DA (4); et
des moyens de réduction au silence (19; 20, 21) réagissant à un changement du signal de spécification de mode de reproduction (112) en réduisant une valeur du second code MIC (104) provenant du décodeur MIC-DA (4).

**2.** Le codeur/décodeur de parole ayant des fonctions d'enregistrement et de reproduction de la parole selon la revendication 1, dans lequel les moyens de réduction au silence (19; 20, 21) comprennent un circuit de génération de signal de restauration (19) qui réagit à un changement du signal de spécification de mode de reproduction (112) en appliquant un signal de restauration (122) au décodeur MIC-DA (4), pour restaurer le décodeur MIC-DA (4) à un état initial.

**3.** Le codeur/décodeur de parole ayant des fonctions d'enregistrement et de reproduction de la parole selon la revendication 1 ou 2, dans lequel les moyens de réduction au silence (19; 20, 21) comprennent:

des moyens temporisateurs (21) réagissant à un changement du signal de spécification de mode de reproduction (112) en activant et en émettant un signal de sélection (124); et
un commutateur de sélection de code de sortie de reproduction (20) connecté de façon à recevoir le code MIC-DA (120) qui est lu dans les moyens de mémoire (8), et un code MIC-DA prédéterminé pour une valeur fixée correspondant à une valeur différentielle ayant la plus petite valeur absolue, pour sélectionner et émettre le code MIC-DA prédéterminé vers le commutateur de sélection de sortie de reproduction (18) sous l'effet de l'activation du signal de sélection (124).

**4.** Le codeur/décodeur de parole ayant des fonctions d'enregistrement et de reproduction de la parole selon l'une des revendications 1 à 3, dans lequel le décodeur MIC-DA (4) a un coefficient utilisé dans le traitement de décodage MIC-DA qui est restauré à une valeur initiale prédéterminée sous l'effet du signal de restauration (122).

5. Le codeur/décodeur de parole ayant des fonctions d'enregistrement et de reproduction de la parole selon l'une des revendications 1 à 4, comprenant en outre un commutateur de sélection de sortie d'émission (22) pour sélectionner un code parmi le premier code MIC (101) provenant du codeur MIC (2), et le second code MIC (104) provenant du décodeur MIC-DA (4), conformément à un signal de spécification de sortie d'émission (128), pour appliquer le signal MIC sélectionné au codeur MIC-DA (3).

6. Procédé pour faire fonctionner un codeur/décodeur de parole qu'on peut faire fonctionner dans un mode de communication, un mode d'enregistrement de parole et un mode de reproduction de parole, comprenant les étapes suivantes :

dans le mode de fonctionnement de communication, on effectue un processus de codage à rendement élevé sur un signal de parole analogique d'entrée, pour produire des données de parole codées avec un rendement élevé, pour l'émission vers un interlocuteur, et on effectue un processus de décodage à rendement élevé sur des données de parole codées à rendement élevé qui sont fournies par l'interlocuteur par l'intermédiaire d'un décodeur (4, 5), pour produire un signal de parole analogique pour l'émission vers l'extérieur,
dans le mode de fonctionnement d'enregistrement, on enregistre dans une mémoire (8) les données de parole codées avec un rendement élevé qui sont produites de façon interne, ou celles qui sont reçues à partir de l'interlocuteur;
dans le mode de fonctionnement de reproduction, on lit dans la mémoire les données de parole codées avec un rendement élevé, pour effectuer le traitement de décodage à rendement élevé sur les données de parole lues, dans le décodeur; et
dans une commutation entre le mode de fonctionnement de communication et le mode de fonctionnement de reproduction, on atténue la signal de parole analogique pour l'émission vers l'extérieur.

7. Le procédé selon la revendication 6, dans lequel le décodeur (4, 5) comprend un premier décodeur (4) pour effectuer un traitement de décodage différentiel adaptatif sur des données de parole codées à rendement élevé qui sont reçues, et un second décodeur (5) pour effectuer en outre un traitement de décodage non adaptatif sur les données de parole qui sont reçues à partir du premier décodeur, pour produire le signal de parole analogique, et dans lequel l'étape d'atténuation comprend l'étape de restauration du premier décodeur à un état initial.

8. Le procédé selon la revendication 6, dans lequel le décodeur (4, 5) comprend un premier décodeur (4) pour effectuer un décodage différentiel adaptatif sur les données de parole codées à rendement élevé qui sont reçues, et un second décodeur (5) pour effectuer en outre un décodage non adaptatif sur les données de parole qui sont décodées et fournies par le premier décodeur, et dans lequel l'étape d'atténuation comprend l'étape qui consiste à appliquer un code différentiel adaptatif prédéterminé, correspondant à une plus petite valeur différentielle absolue, au premier décodeur pendant une durée prédéterminée.

9. Le procédé selon l'une des revendications 6 à 8, dans lequel l'étape d'accomplissement d'un processus de codage à rendement élevé comprend l'étape qui consiste à effectuer un processus de codage MIC sur le signal analogique d'entrée, et à effectuer un processus de codage différentiel adaptatif sur le signal de parole codé en MIC, pour générer les données de parole codées à rendement élevé, et dans lequel l'étape d'accomplissement d'un processus de décodage à rendement élevé comprend l'étape d'accomplissement d'un processus de décodage MIC différentiel adaptatif sur les données de parole codées à rendement élevé qui sont reçues, et en outre l'accomplissement d'un processus de décodage MIC non adaptatif sur les données de parole qui ont été soumises au traitement de décodage MIC différentiel adaptatif, et dans lequel le procédé comprend en outre l'étape qui consiste à fournir sélectivement les données de parole soumises au processus de décodage MIC différentiel adaptatif, à la place du signal de parole codé en MIC.

FIG.1

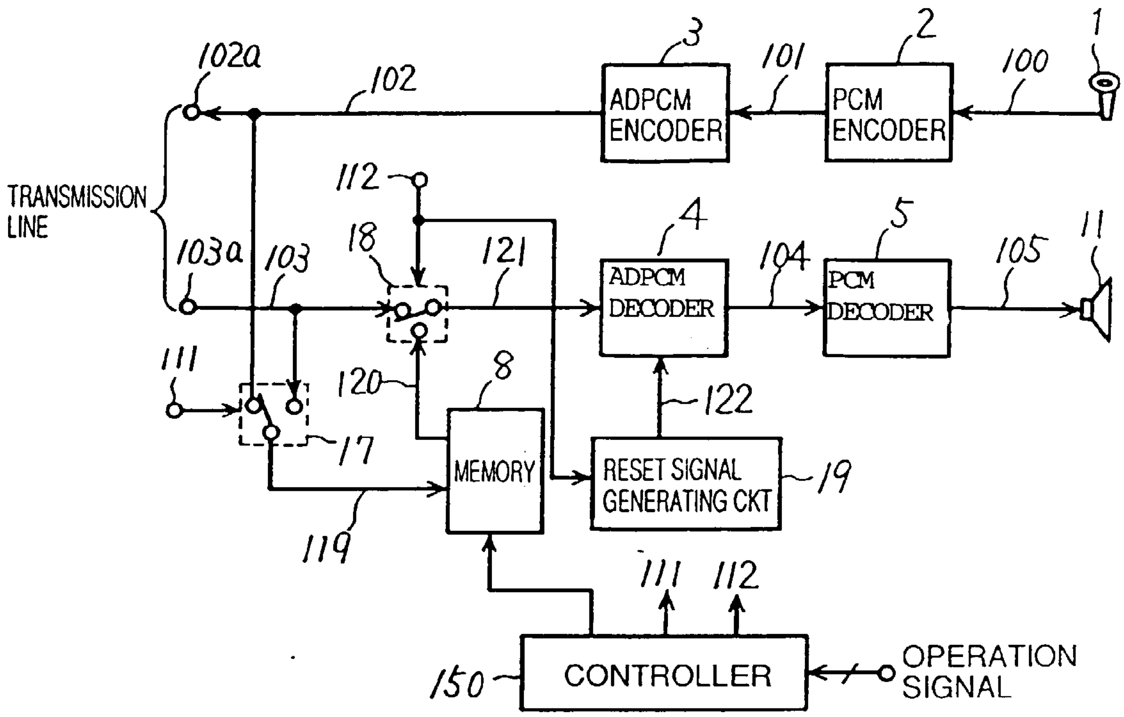

1
2
3
100
101
102
102a
PCM ENCODER
ADPCM ENCODER
TRANSMISSION LINE
112
4
5
11
103a
103
18
121
104
105
ADPCM DECODER
PCM DECODER
111
120
8
122
17
MEMORY
RESET SIGNAL GENERATING CKT
19
119
111
112
150
CONTROLLER
OPERATION SIGNAL


FIG.2

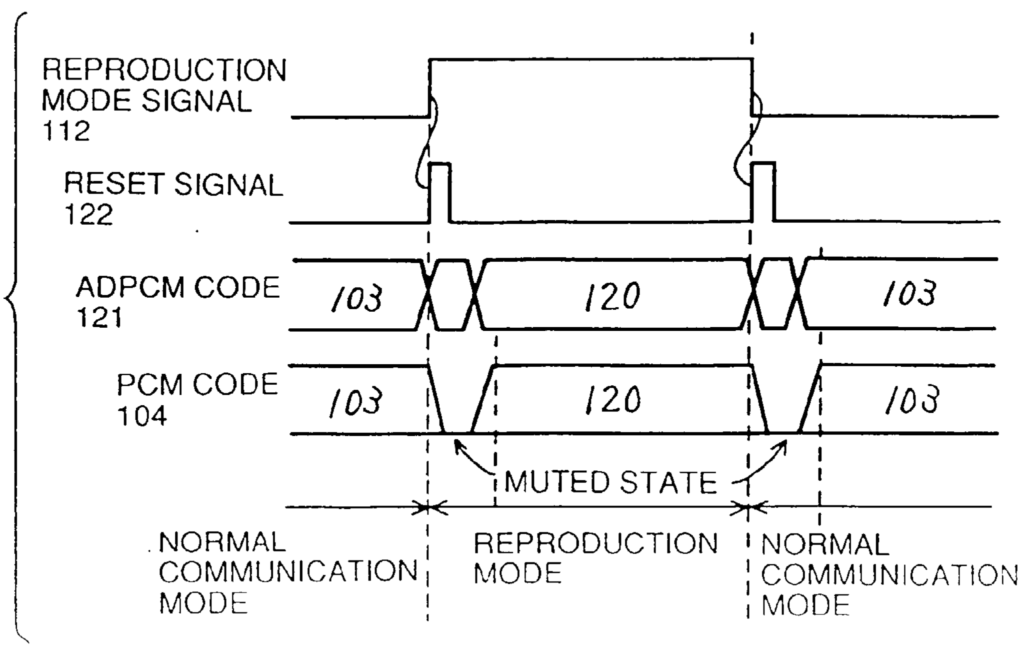

REPRODUCTION MODE SIGNAL 112
RESET SIGNAL 122
ADPCM CODE 121
103
120
103
PCM CODE 104
103
120
103
MUTED STATE
NORMAL COMMUNICATION MODE
REPRODUCTION MODE
NORMAL COMMUNICATION MODE

FIG.3

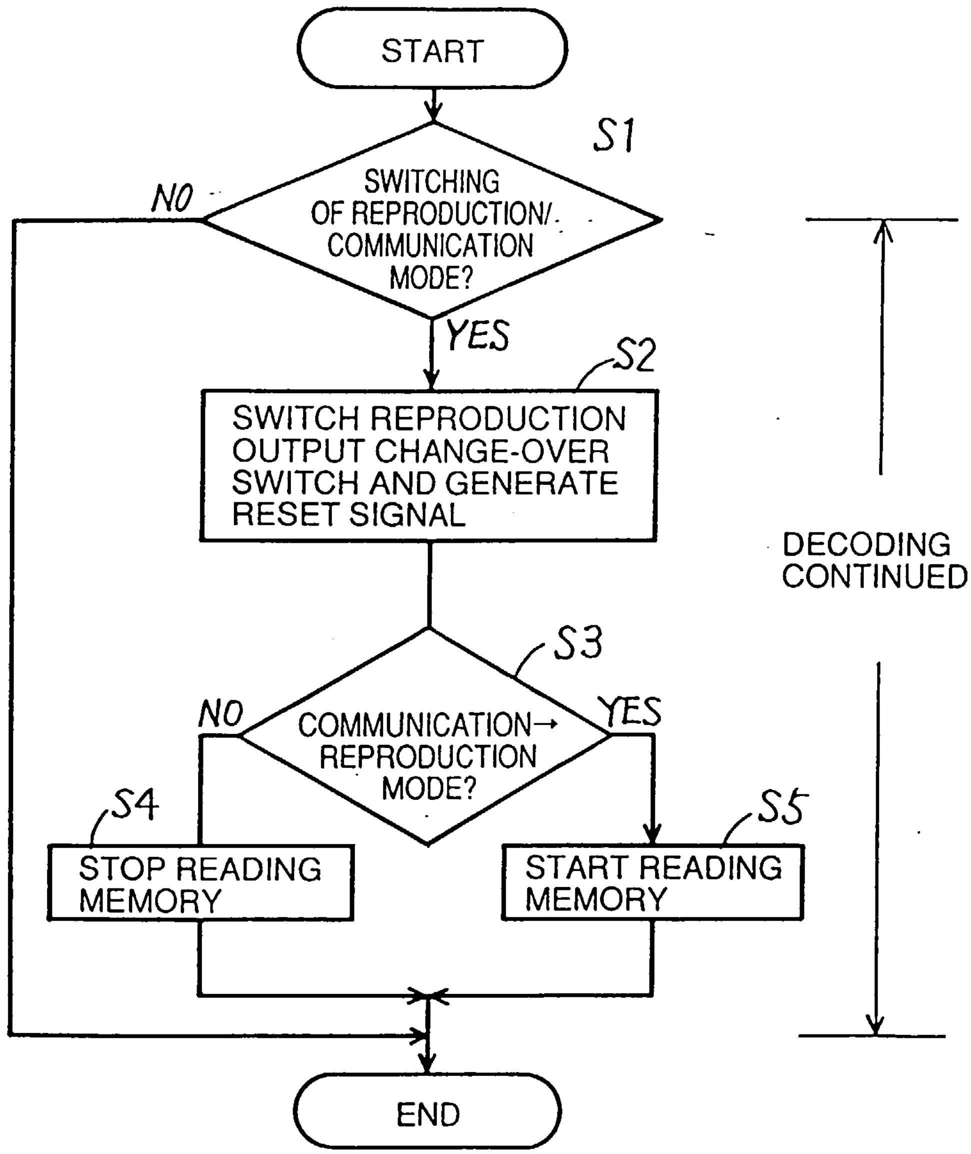
START
S1
SWITCHING OF REPRODUCTION/ COMMUNICATION MODE?
NO
YES
S2
SWITCH REPRODUCTION OUTPUT CHANGE-OVER SWITCH AND GENERATE RESET SIGNAL
DECODING CONTINUED
S3
COMMUNICATION→ REPRODUCTION MODE?
NO
YES
S4
STOP READING MEMORY
S5
START READING MEMORY
END

FIG.4

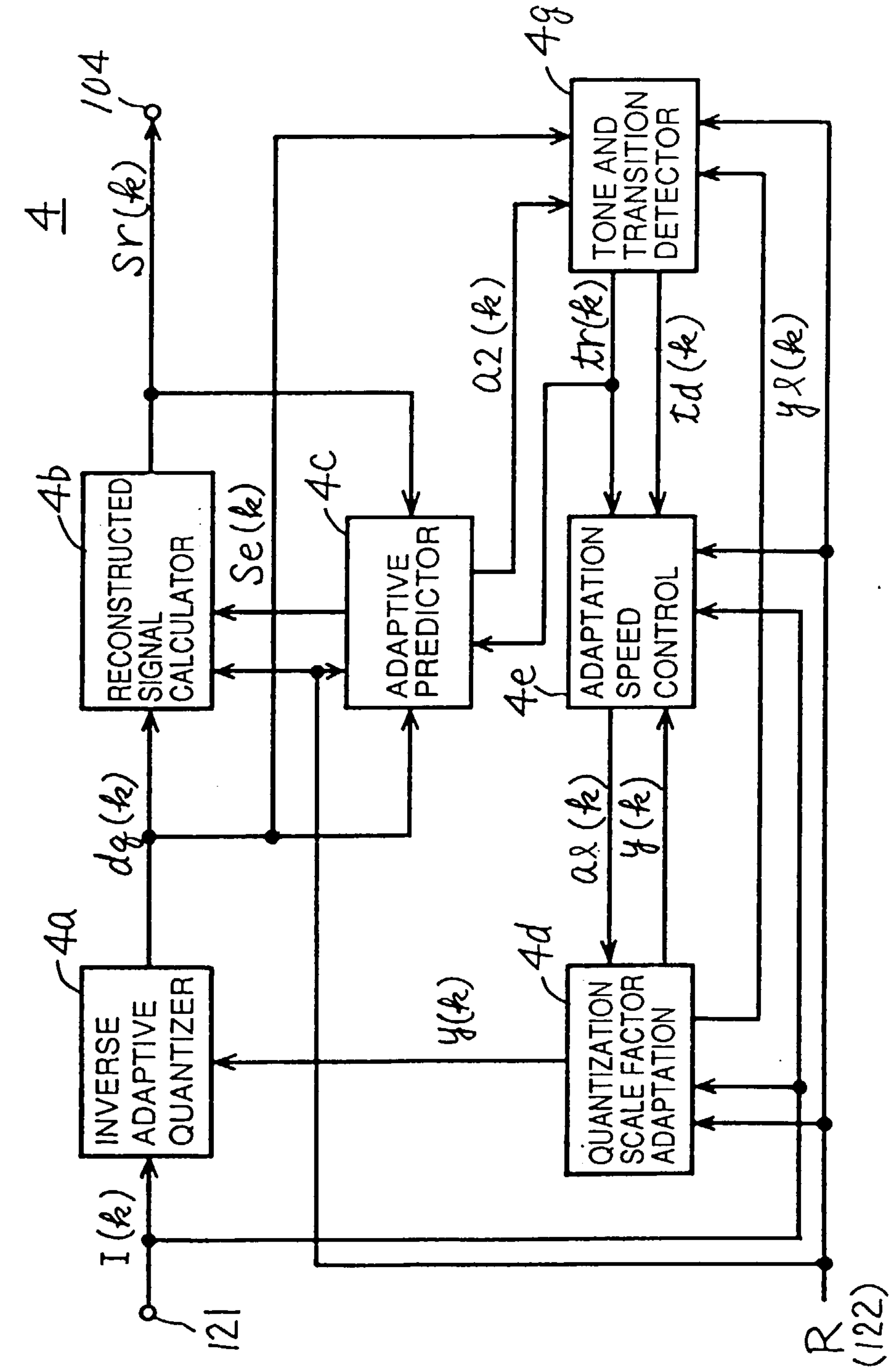
4
104
Sr(k)
4g
TONE AND TRANSITION DETECTOR
4b
RECONSTRUCTED SIGNAL CALCULATOR
Se(k)
4c
ADAPTIVE PREDICTOR
a2(k)
tr(k)
td(k)
yl(k)
4e
ADAPTATION SPEED CONTROL
4a
INVERSE ADAPTIVE QUANTIZER
dq(k)
al(k)
y(k)
4d
QUANTIZATION SCALE FACTOR ADAPTATION
y(k)
I(k)
121
R
(122)

FIG.5A

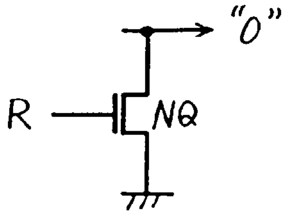


FIG.5B

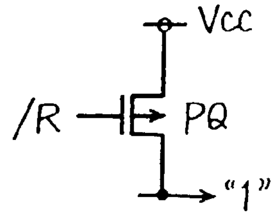


FIG.6A

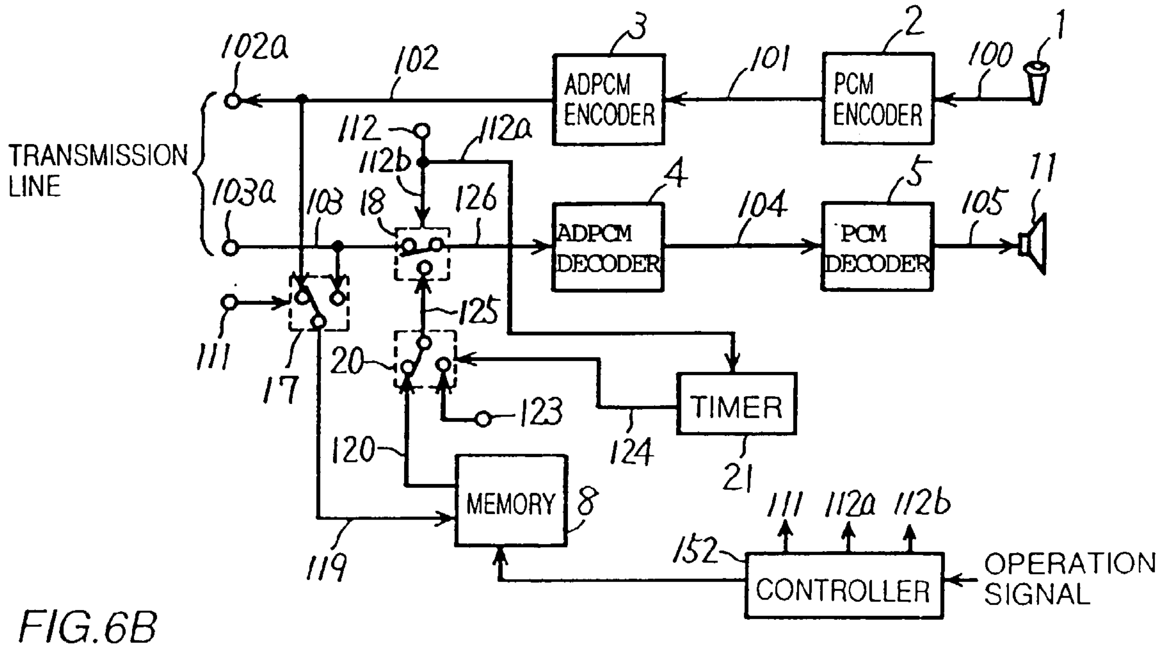


FIG.6B

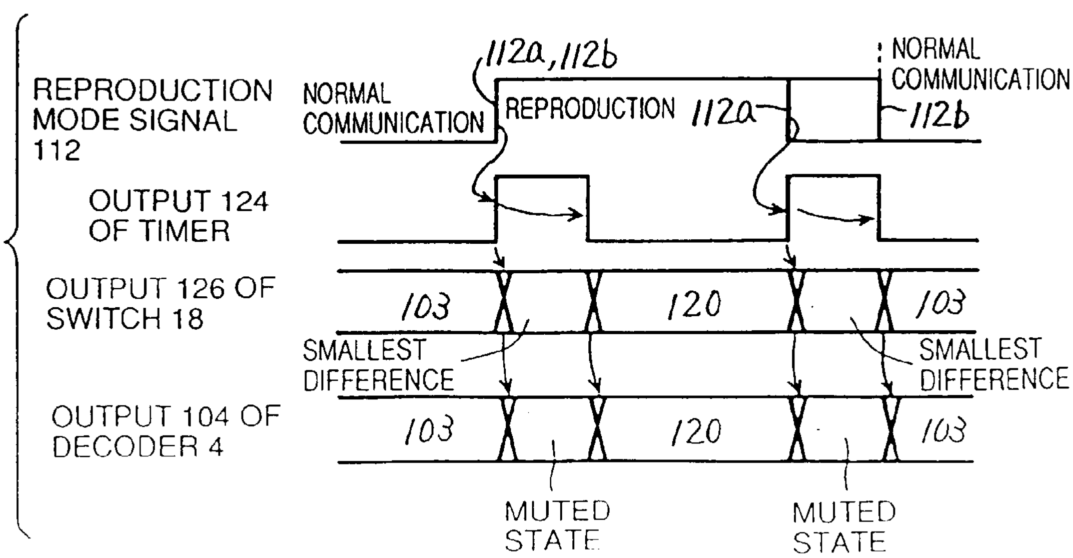

FIG.7

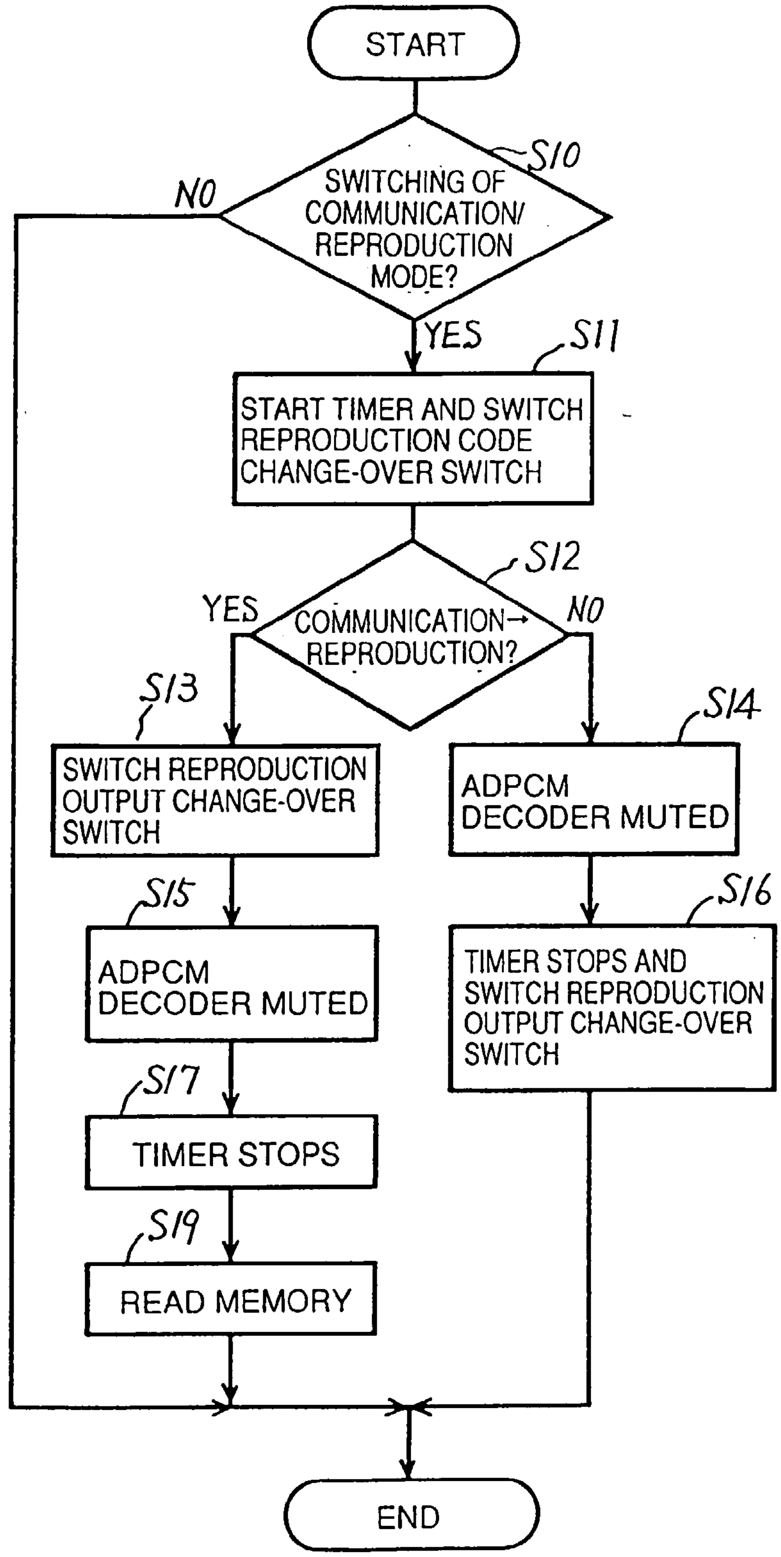
START
SWITCHING OF COMMUNICATION/ REPRODUCTION MODE?
S10
NO
YES
S11
START TIMER AND SWITCH REPRODUCTION CODE CHANGE-OVER SWITCH
S12
COMMUNICATION→ REPRODUCTION?
YES
NO
S13
SWITCH REPRODUCTION OUTPUT CHANGE-OVER SWITCH
S14
ADPCM DECODER MUTED
S15
ADPCM DECODER MUTED
S16
TIMER STOPS AND SWITCH REPRODUCTION OUTPUT CHANGE-OVER SWITCH
S17
TIMER STOPS
S19
READ MEMORY
END

FIG.8A

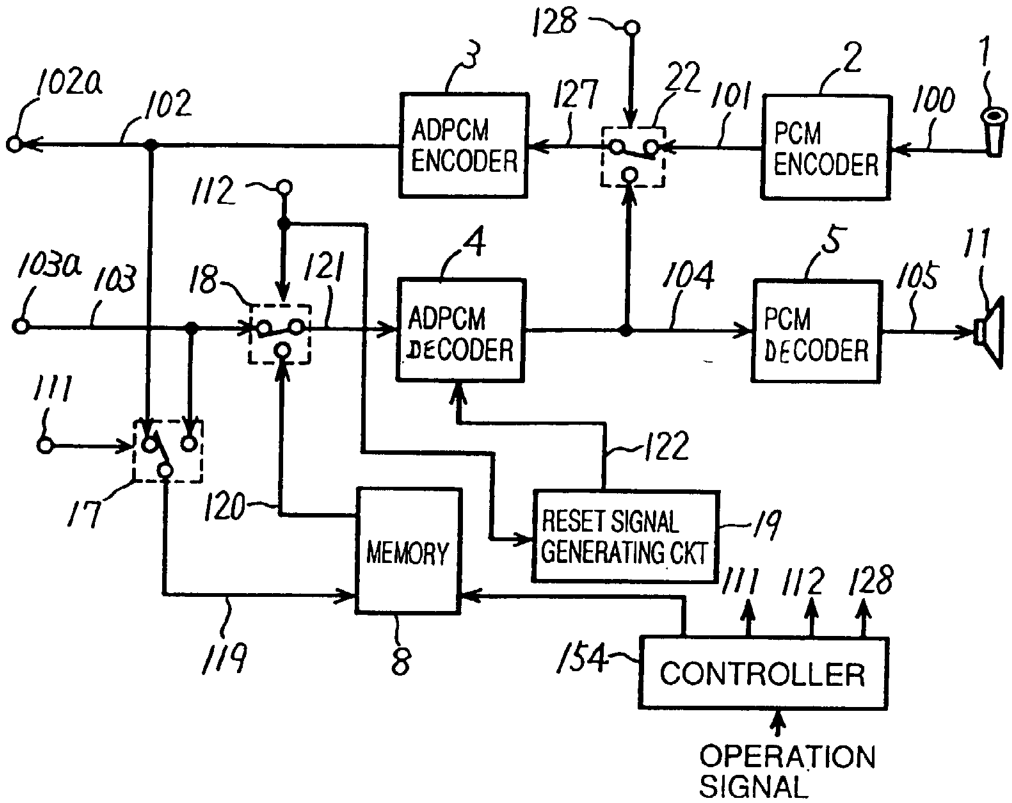

128
3
22
2
1
102a
102
ADPCM ENCODER
127
101
PCM ENCODER
100
112
4
5
11
103a
103
18
121
ADPCM DECODER
104
PCM DECODER
105
111
122
17
120
RESET SIGNAL GENERATING CKT
19
MEMORY
111 112 128
119
8
154
CONTROLLER
OPERATION SIGNAL


FIG.8B

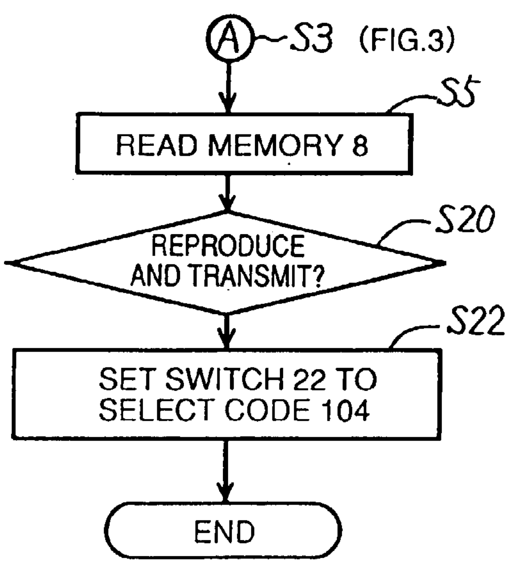

A
S3 (FIG.3)
S5
READ MEMORY 8
S20
REPRODUCE AND TRANSMIT?
S22
SET SWITCH 22 TO SELECT CODE 104
END

FIG.9A

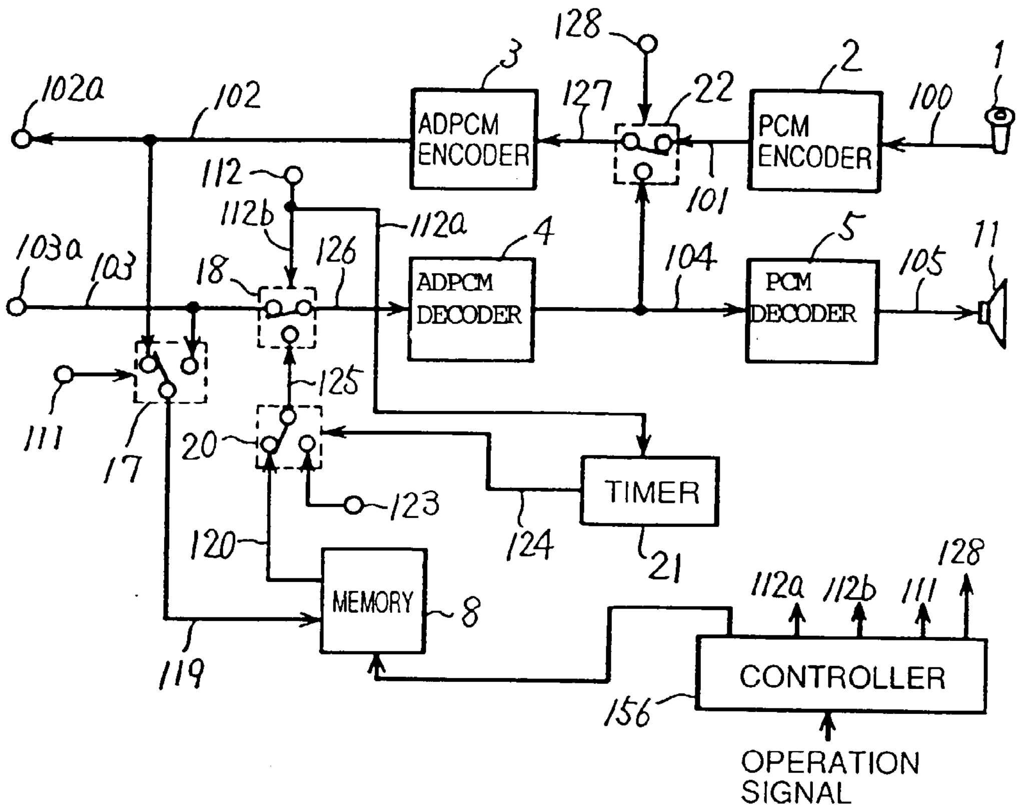
128
3
2
1
102a
102
127
22
100
ADPCM ENCODER
PCM ENCODER
112
112b
112a
101
103a
103
18
126
4
104
5
105
11
ADPCM DECODER
PCM DECODER
125
111
17
20
TIMER
123
120
124
21
128
112a
112b
111
MEMORY
8
119
CONTROLLER
156
OPERATION SIGNAL

FIG.9B

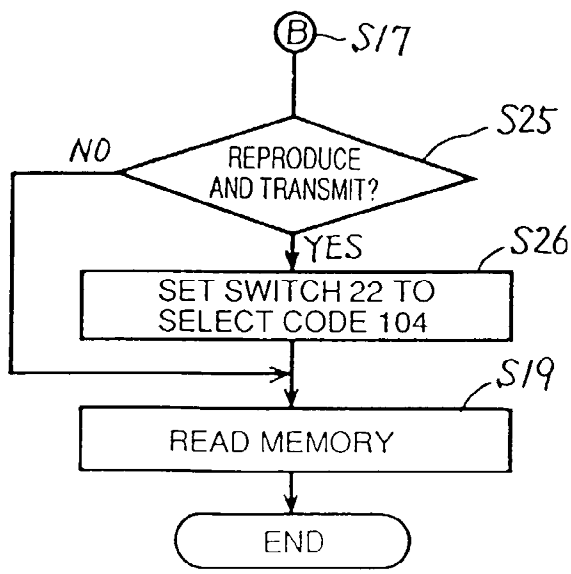
B
S17
S25
NO
REPRODUCE AND TRANSMIT?
YES
S26
SET SWITCH 22 TO SELECT CODE 104
S19
READ MEMORY
END

FIG.10

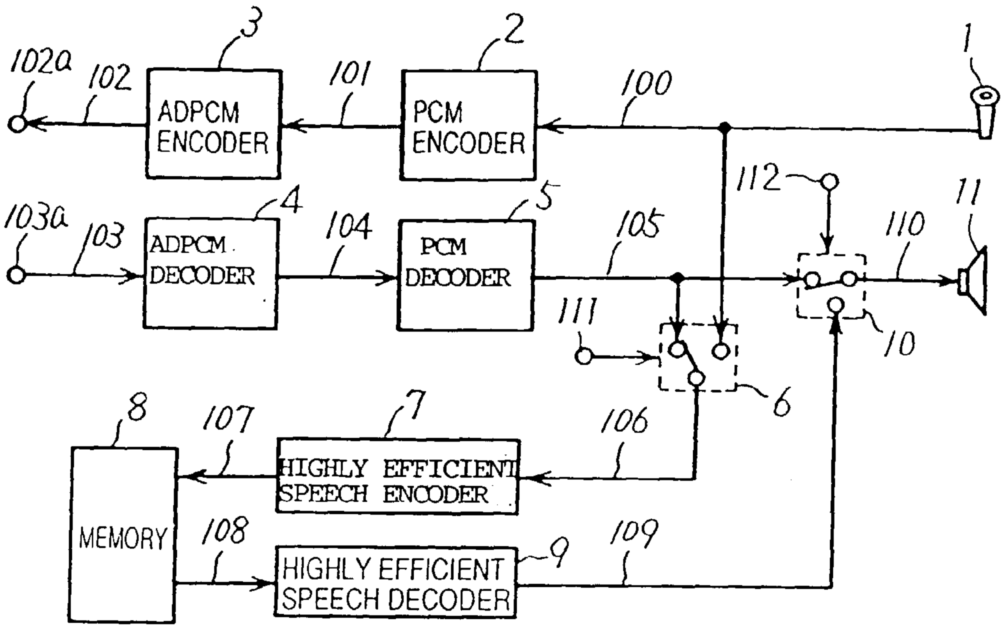


FIG.11A

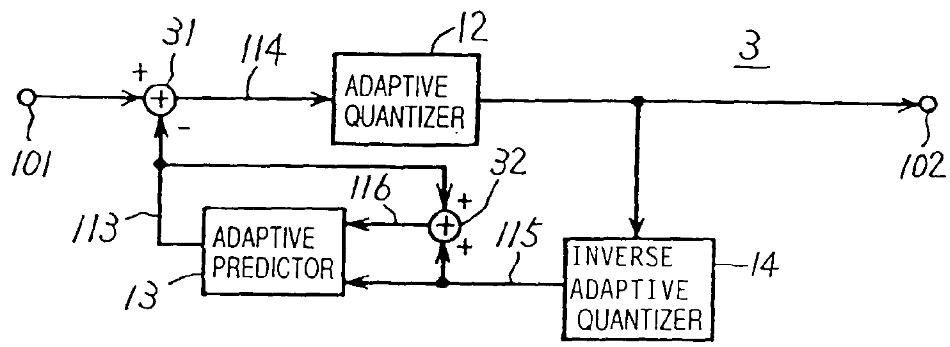


FIG.11B